# EUROPÄISCHE PATENTSCHRIFT

(11) **EP 2 748 906 B1**
(45) Veröffentlichungstag und Bekanntmachung des Hinweises auf die Patenterteilung: **14.11.2018**
(21) Anmeldenummer: 11767224.6
(22) Anmeldetag: 29.09.2011
(51) Int. Cl.: H02M 1/32, H02H 7/122, H02M 7/49, H02M 7/483

(54) **KURZSCHLUSSSTROMENTLASTUNG FÜR SUBMODUL EINES MODULAREN MEHRSTUFENUMRICHTERS (MMC)**
SHORT CIRCUIT CURRENT PROTECTION FOR MODULE OF A MODULAR MULTILEVEL CONVERTER (MMC)
PROTECTION CONTRE LES COURTS-CIRCUITS DANS UN MODULE POUR UN CONVERTISSEUR MULTI-NIVEAUX MODULAIRE (MMC)

(43) Veröffentlichungstag der Anmeldung: 02.07.2014
(73) Patentinhaber: Siemens Aktiengesellschaft, 80333 München (DE); Infineon Technologies Bipolar GmbH & Co. KG, 59581 Warstein (DE); Fraunhofer-Gesellschaft zur Förderung der angewandten Forschung e.V., 80686 München (DE)
(72) Erfinder: BILLMANN, Markus, 91448 Emskirchen (DE); DORN, Jörg, 96155 Buttenheim (DE); GAMBACH, Herbert, 91080 Uttenreuth (DE); WAHLE, Marcus, 90766 Fürth (DE)
(86) Internationale Anmeldenummer: PCT/EP2011/066996
(87) Internationale Veröffentlichungsnummer: WO 2013/044961

(56) Entgegenhaltungen:
- EP-A2- 0 785 625
- WO-A1-2006/104430
- WO-A1-2006/136123
- WO-A1-2010/081555
- CN-A- 101 819 970
- DE-A1- 10 323 220
- JP-A- 2001 238 460
- US-A1- 2008 205 093
- A. + Nonymous: "FZ800R12KF4 - Marketing information", , 31 January 1998 (1998-01-31), pages 1-5, XP055484537, Retrieved from the Internet: URL:http://www.bjrtd.com/pdf/fz800r12kf4.p df [retrieved on 2018-06-14]

## Beschreibung

Die Erfindung betrifft ein Submodul für einen Mehrpunkt-Umrichter mit einem unipolaren Energiespeicher, zwei Anschlussklemmen und einer Halbleiterschaltung, die wenigstens zwei ansteuerbare Leistungshalbleiterschalter aufweist, denen jeweils eine separate Freilaufdiode gegensinnig parallel geschaltet ist, wobei dem unipolaren Energiespeicher niederinduktiv wenigstens ein Halbleiterbauelement parallel geschaltet ist, das im Fehlerfall den Energiespeicher überbrückt.

Ein solches Submodul ist aus der DE 103 23 220 A1 bereits bekannt. Das dort gezeigte Submodul weist vier steuerbare Leistungshalbleiterschalter in Gestalt von IGBTs auf, denen jeweils eine Freilaufdiode gegensinnig parallel geschaltet ist. Ferner ist ein Speicherkondensator vorgesehen, mit dem die IGBTs zusammen eine so genannte Vollbrückenschaltung ausbilden. Um bei einem Einsatz von industrieüblichen IGBT-Modulen, deren Chips emitterseitig über Bonddrähte miteinander verbunden sind, ein Abschmelzen oder Herausreißen der Bonddrähte mit einer Lichtbogenbildung im Gefolge zu vermeiden, ist dem Speicherkondensator gleichspannungsseitig ein Halbleiterbauelement parallel geschaltet. Dabei sind das Halbleiterbauelement und der Speicherkondensator niederinduktiv miteinander verbunden, so dass das Halbleiterbauelement den vom Speicherkondensator gespeisten Kurzschlussstrom im Wesentlichen übernimmt, sobald es in seinen leitenden Zustand überführt wird. Als Halbleiterbauelement wird beispielsweise eine Rückschwingdiode oder aber ein Thyristor vorgeschlagen, dessen Steueranschluss mit einer Erkennungsschaltung verbunden ist, die zur Erkennung eines außergewöhnlich schnellen Stromanstieges oder der Überschreitung eines maximalen Stromes oder einer maximalen Spannung eingerichtet ist und in diesem Fall den Thyristor zündet. Der Thyristor oder die Rückschwingdiode sind so ausgelegt, dass beispielsweise aufgrund eines einstellenden hohen Stromanstiegs (di/dt) zerstört wird. Das Halbleiterbauelement wird dabei in seinen leitenden Zustand überführt. Dies wird vor allem in der englischsprachigen Literatur als "Durchlegieren" bezeichnet. Aufgrund des parallelen leitenden Halbleiterbauelements entlädt sich der Speicherkondensator, so dass die IGBTs und die Freilaufdioden im günstigsten Falle nicht zerstört werden. Die unzerstörten Freilaufdioden stellen dann zusammen mit dem durchlegierten Halbleiterbauelement in beiden Stromrichtungen eine leitende Verbindung zwischen den Anschlussklemmen des Submoduls bereit. Mit anderen Worten ist das fehlerhafte Submodul überbrückt. Eine solche Überbrückung ist vorteilhaft, da die zweipoligen Submodule im Bereich der Hochspannungsenergieübertragung in der Regel in Reihenschaltungen eingesetzt werden. Aufgrund der hier herrschenden hohen Spannungen umfassen solche Reihenschaltungen mehrere hundert Submodule. Es liegt auf der Hand, dass der Ausfall eines einzigen Submoduls nicht zu einem Abschalten der gesamten Anlage führen darf. Durch das Überbrücken des Submoduls mittels der Freilaufdiode und dem durchlegierten Halbleiterbauelement kann jedoch der Umrichter, in dem das Submodul verbaut ist, weiterbetrieben werden, wobei die Funktion des fehlerhaften Submoduls von den restlichen Submodulen der Reihenschaltung übernommen wird.

Dem vorbekannten Submodul haftet der Nachteil an, dass nicht für jeden Fehlerfall sichergestellt ist, dass die Freilaufdioden unbeschädigt bleiben. Vielmehr kann es trotz der Wirkung des niederinduktiv angebundenen Halbleiterbauelements zu so hohen Fehlerströmen in den Freilaufdioden kommen, dass deren Bonddrähte herausgerissen werden oder schmelzen. Dies führt zu einer Zerstörung der Freilaufdioden, so dass die Anschlussklemmen des fehlerhaften Submoduls nicht mehr überbrückt sind.

Aus der WO 2010/081555 ist ferner ein Submodul für einen modularen Mehrstufenumrichter (MMC) bekannt. Leistungshalbleiterschalter sowie die dazu antiparallel geschalteten Freilaufdioden des Submoduls sind in Form von Chips in einer sogenannten Presspack-Anordnung zwischen leitenden Platten verspannt. Parallel zu den Halbleiter-Chips ist zwischen den leitenden Platten zusätzlich ein mechanischer Schalter angeordnet. Der mechanische Schalter wird bei einem Fehler eines der Halbleiter ausgelöst, so dass eine Bypass-Verbindung zwischen den leitenden Platten entsteht.

Ein weiterer Submodul für einen MMC ist in der WO 2006/136123 A1 offenbart. Das dortige Submodul umfasst eine Schutzeinrichtung aus zwei gegensinnig verlaufenden Leiterabschnitten, die aufgrund einer gegenseitigen Abstoßung bei hohen Fehlerströmen eine Überbrückung des gesamten Submoduls bewirken. Ein zusätzliches zwischen den Klemmen des Submoduls angeordnetes Sicherungselement in Form einer Scheibenzellendiode wird im Fehlerfall zerstört und bildet dabei einen zusätzlichen Strompfad aus.

Aus der WO 2006/1014430 A1 ist ferner eine Ventileinheit für ein Umrichterventil eines Spannungszwischenkreisumrichters mit einer Überwachungseinrichtung bekannt. Jede Ventileinheit umfasst dabei parallel geschaltete Halbleiterschalter. Die bekannte Überwachungseinrichtung stellt einen Fehlerfall eines Halbleiters des Stromrichterventils fest, worauf die Halbleiter der betreffenden Ventileinheit in einen Zustand mit einem geschlossenen Stromkreis in der Ventileinheit überführt werden.

Die EP 0 785 625 A2 offenbart eine Schutzanordnung für eine Schaltvorrichtung, bei der ein Thyristor parallel zur Schaltvorrichtung angeordnet ist und in einem Fehlerfall einen dauerhaften Überbrückungsstrompfad niedriger Impedanz für die Schaltvorrichtung ausbilden kann.

Die US 2008/0205093 A1 beschreibt eine Umrichteranordnung, bei der in einem Halbleitermodul zusätzlich zu den Freilaufdioden parallele Schutzdioden parallel zum Halbleiterschaltelement vorgesehen sind. Diese Dioden können als druckkontaktierte Dioden ausgeführt sein.

Aufgabe der Erfindung ist es daher, ein Submodul der eingangs genannten Art bereitzustellen, das im Fehlerfall die beiden Anschlussklemmen des Submoduls zuverlässig überbrückt.

Die Erfindung löst diese Aufgabe durch die Merkmale des unabhängigen Anspruchs 1. Erfindungsgemäß ist ein Submodul bereitgestellt, bei dem unabhängig von der Wahl der Leistungshalbleiterschalter im Fehlerfall ein Strompfad in beiden Richtungen bereitgestellt ist, der ausschließlich über druckkontaktierte Halbleiter verläuft. Die druckkontaktierten Halbleiterbauelemente sind auf Siliziumbasis gefertigt. Dies trifft auch auf die Scheibenzellendiode zu. Siliziumhalbleiterchips weisen die Eigenschaft auf, dass sie bei zu großen Strom- oder Spannungsgradienten oder aber bei einem zu hohen über sie fließenden Strom oder einer zu großen an ihnen abfallenden Spannung zerstört werden, wobei sie in einen leitenden Zustand übergehen. Diese Eigenschaft wird in der englischen Literatur mit "Durchlegieren" oder als "Conduct on Fail" bezeichnet. Im Fehlerfall sind somit niederinduktive Strompfade in beiden Richtungen bereitgestellt, die das fehlerhafte Submodul überbrücken. Darüber hinaus kann der Energiespeicher über das wenigstens eine Halbleiterbauelement sicher entladen werden, wobei aufgrund der niederinduktiven Anbindung vermieden wird, dass der Leistungshalbleiterschalter mit einem hohen Fehlerstrom belastet wird. Der Leistungshalbleiterschalter kann somit als industrieüblicher Leistungshalbleiterschalter ausgebildet sein, der also eine Vielzahl von Leistungshalbleiterchips aufweist, deren Lastanschlüsse über Bonddrähte miteinander verbunden sind. Im Fehlerfall kann es in den Bonddrähten nicht mehr zu so hohen Stromdichten kommen, dass auf Grund eines Aufschmelzens oder ein Herausreißens der Bonddrähte bewirkt durch hohe magnetische Feldstärke ein Lichtbogen entsteht. Erfindungsgemäß ist eine Explosion des Submoduls daher vermieden und sichergestellt, dass die Entladung des Energiespeichers im Wesentlichen über die druckkontaktierten Halbleiter erfolgt. Die mechanische Halterung der Scheibenzellendioden erfolgt mit Hilfe der Kollektor- und Emitterplatte.

Selbst wenn aufgrund der Entladung des Energiespeichers oder wegen eines Kurzschlusses im angeschlossenen Netz ein hoher Fehlerstrom durch die Freilaufdioden fließt, werden diese den Strompfad über das erfindungsgemäße Submodul nicht unterbrechen. Vielmehr werden die Freilaufdioden selbst im Falle ihrer Zerstörung ebenfalls leitend, so dass das fehlerhafte Submodul zuverlässig überbrückt ist.

Erfindungsgemäß weist die Scheibenzellendiode eine elastische und elektrisch leitende Deformationsschicht auf. Die elastisch verformbare Deformationsschicht verhindert eine Zerstörung der jeweiligen Scheibenzellendiode aufgrund der sich einstellenden mechanischen Spannkräfte. Hierzu weist die Deformationsschicht eine geeignete Elastizität auf. Beispielsweise besteht die Deformationsschicht aus Kupfer und weist eine zweckmäßige Dicke auf, die von dem Druck der Verspannung abhängig ist. Die Scheibenzellendiode ist selbstverständlich gegensinnig parallel zur Durchlassrichtung des Leistungshalbleiterschalters geschaltet, dem diese parallel geschaltet ist. Der parallel geschaltete Leistungshalbleiterschalter weist ausschließlich steuerbare Leistungshalbleiterchips, wie beispielsweise IGBTs, GTOs, IGCTs oder dergleichen, auf. Die als Freilaufdiode wirkenden Dioden sind in Gestalt der Scheibenzellendiode außerhalb des Halbleitergehäuses des Leistungshalbleiterschalters angeordnet. Hierbei weisen alle steuerbaren Leistungshalbleiterchips des Leistungshalbleiters eine gemeinsame Durchlassrichtung auf, so dass eine Steuerung des Stromflusses in dieser Richtung ermöglicht ist. Die nicht steuerbare Durchlassrichtung der Scheibenzellendiode ist entgegengesetzt zur Durchlassrichtung der steuerbaren Leistungshalbleiterchips des Leistungshalbleiters ausgerichtet.

Zur Vermeidung von Bonddrähten ist jede Scheibenzellendiode druckkontaktiert. Dazu ist sie Teil einer Schaltungseinheit, die über zweckmäßigerweise metallische Kollektor- und Emitterplatte verfügt. Die Verspannung erfolgt mit Hilfe der besagten Kollektor- und Emitterplatte, zwischen denen die Scheibenzellendiode angeordnet ist. Hierbei dienen Spannmittel zum Aufbau einer Spannkraft zwischen den besagten Platten. Die Kollektor- und Emitterplatten sind elektrisch leitend und bevorzugt eben ausgebildet. Erfindungsgemäß ist es daher möglich, dass mehrere Schaltungseinheiten in einer Reihenschaltung elektrisch miteinander verbunden sind, wobei die Schaltungseinheiten aufeinander gestapelt und als Stapel verspannt werden. Über den genauen Aufbau der Halbleiterschaltung wird später noch genauer eingegangen werden.

Gemäß einer bevorzugten Ausgestaltung ist das, eines der oder jedes Halbleiterbauelement ein Thyristor, dessen Steuerungsanschluss mit Mitteln zum Erkennen des Fehlerfalls verbunden ist, wobei der Thyristor so ausgelegt ist, dass er nach seiner Zündung aufgrund des sich einstellenden Fehlerstroms zerstört wird und anschließend leitend bleibt. Gemäß dieser bevorzugten Ausgestaltung der Erfindung ist ein Thyristor dem Energiespeicher niederinduktiv parallel geschaltet. Hiermit ist im Sinne der Erfindung gemeint, dass die Induktivität des über das oder die Halbleiterbauelemente führenden Strompfads geringer ist als die Induktivität des Strompfads, welcher über die Halbleiterschaltung führt. Auf diese Art und Weise ist sichergestellt, dass der Strom im Fehlerfall nach dem Kurzschließen des Thyristors oder dem Durchlegieren eines sonstigen Halbleiterbauelements über das oder die Halbleiterbauelemente und eben nicht über Teile der Halbleiterschaltung fließt. Der Thyristor, der hier auch als Entladethyristor bezeichnet wird, ist dabei so orientiert, dass er in seinem leitenden Zustand für eine Überbrückung oder mit anderen Worten einen Kurzschluss des Energiespeichers sorgt. Durch die Zündung des Thyristors wird somit der Energiespeicher gezielt und aktiv entladen. Hierbei fließt aufgrund der niederinduktiven Anbindung der Fehlerstrom nahezu ausschließlich über den Thyristor, der insbesondere wegen den sich dabei ergebenden hohen Stromanstiegsgeschwindigkeiten zerstört wird und in einen leitfähigen Zustand übergeht. Nach dem Entladen des Energiespeichers ist somit in beiden Richtungen ein leitender Strompfad parallel zum Energiespeicher bereitgestellt. Je nach Ausgestaltung der Halbleiterschaltung fließt der Strom zwischen den beiden Anschlussklemmen über die Scheibenzellendioden und/oder den durchlegierten Thyristor, der hier auch als Entladethyristor bezeichnet wird.

Vorteilhafterweise weisen die Mittel zum Erkennen des Fehlerfalls eine Sensorschaltung auf, die zum Erfassen von Überwachungsgrößen in Gestalt einer Spannungsänderung, einer Stromänderung, eines Stromes und/oder einer an dem Energiespeicher abfallenden Spannung eingerichtet ist, wobei die Sensorschaltung den Entladethyristor zündet, wenn die Überwachungsgröße einen zuvor festgelegten Schwellenwert überschreitet. Eine solche Sensorschaltung ist beispielsweise aus der DE 103 23 220 A1 bekannt. Die Sensorschaltung umfasst vorteilhafterweise einen kapazitiven oder ohmschen Spannungsteiler, bei der einem der Kondensatoren oder Widerstände des Spannungsteilers eine Durchbruchsdiode parallel geschaltet ist. Übersteigt die an dem überbrückten Kondensator und somit an der Durchbruchsdiode abfallende Spannung die Durchbruchsspannung, wird am Steuereingang eines ansteuerbaren Leistungshalbleiters eine Spannung erzeugt, die schließlich für die Entladung eines Ladekondensators sorgt. Der Entladungsstrom wird über eine Zündspule geführt, die mit dem Steuereingang des Thyristors verbunden ist. Die von der Zündspule induzierte Spannung zündet den Thyristor. Bei einer hiervon etwas abgewandelten Variante werden zum Zünden des Thyristors Induktivitäten in Gestalt von Spulen eingesetzt.

Gemäß einer weiteren Ausgestaltung der Erfindung umfassen die Mittel zum Erkennen des Fehlerfalls eine Durchbruchdiode, an der eine Spannung abfällt, die zumindest proportional zu der an dem Energiespeicher abfallenden Spannung ist, wobei die Durchbruchdiode mit dem Steuereingang des Thyristors verbunden und so ausgelegt ist, dass sie bei Überschreiten einer zuvor festgelegten Grenzspannung leitend wird. Die hierbei angesprochene Verbindung zwischen Durchbruchdiode und dem Steuereingang des Thyristors muss im Rahmen der Erfindung - wie oben ausgeführt ist - keineswegs direkt erfolgen. Vielmehr können weitere elektronische oder elektrische Bauteile eingesetzt werden, um möglichst sicher und schnell nach dem Ansprechen der Durchbruchdiode den Thyristor zu zünden. In dem Zusammenhang sei wieder auf die DE 103 23 220 A1 verwiesen.

In einer bevorzugten Ausgestaltung ist die Durchbruchdiode in den Thyristor integriert, so dass eine zusätzliche Ansteuerschaltung überflüssig geworden ist.

Gemäß einer hiervon abweichenden Ausgestaltung umfassen die Mittel zum Erkennen des Fehlerfalls Kopplungsmittel, die ausgangsseitig mit dem Steuereingang des Thyristors verbunden sind, wobei die Kopplungsmittel induktiv mit einer Verbindungsleitung gekoppelt sind, die sich zwischen dem Energiespeicher und der Halbleiterschaltung erstreckt. Durch die induktive Ankopplung wird bei einem schnellen Stromanstieg eine zum Zünden des Thyristors ausreichend hohe Zündspannung erzeugt. Auf diese Art und Weise kann der Thyristor gezündet werden, wobei gleichzeitig ein zu hoher Stromanstieg in der Halbleiterschaltung vermieden ist. Aufwändige Verschaltungen oder Ansteuerelektroniken sind auf diese Art und Weise vermieden.

Zweckmäßigerweise umfassen die Halbleiterbauelemente einen Thyristor und eine Rückschwingdiode, wobei sowohl der Thyristor als auch die Rückschwingdiode dem Energiespeicher niederinduktiv parallel geschaltet sind. Gemäß dieser Ausgestaltung der Erfindung ist für eine Überbrückung und eine gleichzeitig stattfindende Entladung des Energiespeichers auch dann gesorgt, wenn sich Rückschwingprozesse einstellen sollten, die von der den Mitteln zum Erkennen des Fehlerfalls nicht erfasst werden.

Gemäß dem unabhängigen Anspruch 1 weist jeder Leistungshalbleiterschalter in einem Halbleitergehäuse angeordnete Leistungshalbleiterchips mit Chiplastanschlüssen auf, wobei Bonddrähte die Chiplastanschlüsse der Leistungshalbleiterchips miteinander verbinden. Somit sind in dem Submodul industrieübliche Leistungshalbleiterschalter eingesetzt, die Bonddrähte aufweisen, die zum Führen eines Laststroms eingerichtet sind.
Gemäß einer zweckmäßigen Weiterentwicklung verfügt die Schaltungseinheit über eine elektrisch isolierende und umfänglich geschlossene Seitenwand, deren Höhe kleiner ist als die Höhe der Scheibenzellendiode, wobei Emitterplatte, Kollektorplatte und Seitenwand ein Schaltungsgehäuse ausbilden. Gemäß diesem Ausführungsbeispiel nimmt oder nehmen die Scheibenzellendiode(n) mit ihrer Deformationsschicht weiterhin den Druck beim Verspannen auf. Gleichzeitig ist jedoch ein Gehäuse bereitgestellt, das einen Schutz vor Verunreinigungen oder Explosionen bereitstellt. Zum spannungsfreien Halten der Seitenwand weisen die Emitter- und die Kollektorplatte vorteilhafterweise geeignete Haltemittel in Gestalt von Haltenuten, freigebogenen Halteschultern oder dergleichen auf.
Gemäß einer weiteren Variante der Erfindung verfügt das Halbleitergehäuse über eine elektrisch leitende Basisplatte, wobei jeder Leistungshalbleiterchip des Leistungshalbleiterschalters zwei Chiplastanschlüsse aufweist, und mit einem seiner Chiplastanschlüsse elektrisch leitend mit der Basisplatte verbunden ist, so dass die Basisplatte einen der Lastanschlüsse des Leistungshalbleiterschalters ausbildet. Gemäß dieser Variante der Erfindung wird ein zweckmäßig veränderter gebondeter Leistungshalbleiterschalter eingesetzt. Dieser weist Lastanschlüsse auf, die an voneinander abgewandten Gehäuseseiten des Halbleitergehäuses angeordnet sind. Somit ist es möglich, den Leistungshalbleiterschalter mit seiner Basisplatte direkt mit einer der Platten der Schaltungseinheit mechanisch und elektrisch zu verbinden. Zweckmäßigerweise ist die Basisplatte mit der Kollektorplatte verbunden, beispielsweise verschraubt. Der Emitteranschluss des Leistungshalbleiters ist hingegen mit geeigneten elektrischen Verbindungsleitungen an die Emitterplatte angeschlossen.

Bei einer vorteilhaften Ausgestaltung dieser Variante des erfindungsgemäßen Submoduls ist jedes Leistungshalbleiterchip des Leistungshalbleiterschalters flächig mit der Basisplatte oder mit einer elektrisch leitenden Zwischenschicht verbunden, die im elektrischen Kontakt mit der Basisplatte steht. Der Leistungshalbleiterchip kann hierzu mit einer beliebigen Methode flächig mit der Basisplatte direkt oder mit der Zwischenschicht verbunden werden. Vorteilhafterweise ist der Leistungshalbleiterchip flächig aufgelötet.

Zweckmäßigerweise sind Kühlmittel zum Kühlen der Leistungshalbleiterchips vorgesehen. Hierzu erstrecken sich beispielsweise Kühlrohre durch die Kollektor- und/oder Emitterplatte. Diese steht beispielsweise in wärmeleitendem flächigen Kontakt mit einer Basisplatte. Die Kühlrohre sind beispielsweise aus einem nicht leitenden Material gefertigt, das jedoch eine zur Kühlung ausreichende Wärmeleitfähigkeit aufweist. Abweichend hiervon sind in der Kühlplatte rohrförmige Bohrungen ausgebildet, wobei die elektrisch nicht leitenden Kühlrohre fluiddicht in die Bohrungen münden. Als Kühlflüssigkeit eignet sich beispielsweise deionisiertes Wasser. Abweichend hiervon können sich die Kühlrohre jedoch auch durch die Basisplatte selbst erstrecken, die dann auch als Kühlplatte wirkt. Natürlich kann auch die Basisplatte rohrförmige Bohrungen aufweisen.

Zweckmäßigerweise bildet die Halbleiterschaltung zusammen mit dem Energiespeicher eine Halbbrückenschaltung aus. Eine Halbbrückenschaltung verfügt über eine Reihenschaltung von zwei Schaltungseinheiten, wobei eine Anschlussklemme mit dem Potenzialpunkt zwischen den besagten zwei Schaltungseinheiten verbunden ist. Die andere Anschlussklemme ist direkt an eine Klemme des Energiespeichers angeschlossen. Ist der Energiespeicher ein unipolarer Speicherkondensator, ist die besagte Anschlussklemme daher mit einer Platte oder einem Pol des Speicherkondensators verbunden.

Anstelle von zwei einzelnen Schaltungseinheiten kann die Leistungshalbleiterreihenschaltung auch zwei Reihenschaltungen mehrerer Schaltungseinheiten aufweisen. Die Schaltungseinheiten einer Reihenschaltung werden synchron angesteuert, so dass die Reihenschaltung wie ein einzelner Schalter wirkt. Gemäß dieser Ausgestaltung des erfindungsgemäßen Submoduls sind daher zwei Reihenschaltungen von Schaltungseinheiten vorgesehen, wobei die besagten Reihenschaltungen wieder in Reihe geschaltet sind. Die Leistungshalbleiterreihenschaltung mit den beiden Reihenschaltungen von Schaltungseinheiten ist wiederum parallel zum Energiespeicher und somit parallel zum Halbleiterbauelement geschaltet. Eine Anschlussklemme liegt auf dem Potenzialpunkt zwischen den Reihenschaltungen der Schaltungseinheiten, wobei die andere Anschlussklemme wiederum mit einer Klemme des Energiespeichers oder mit einem Pol des Speicherkondensators verbunden ist.

Hiervon abweichend bildet die Halbleiterschaltung zusammen mit dem Energiespeicher eine Vollbrückenschaltung aus. Gemäß dieser Ausgestaltung der Erfindung sind vier Schaltungseinheiten vorgesehen. Dabei bilden jeweils zwei Schaltungseinheiten wieder eine Leistungshalbleiterreihenschaltung aus, die jeweils dem Energiespeicher und somit dem Halbleiterbauelement parallel geschaltet ist. Der Potenzialpunkt zwischen den Schaltungseinheiten ist jeweils mit einer Anschlussklemme verbunden. Statt einer einzigen Schaltungseinheit kann auch bei der Vollbrückenschaltung die Rolle einer einzigen Schaltungseinheit durch eine Reihenschaltung von beispielsweise acht Schaltungseinheiten ausgefüllt werden. Die Leistungshalbleiterschalter der in Reihe geschalteten Schaltungseinheiten werden wieder synchron angesteuert. Dabei können beispielsweise die Kollektorplatte der einen Schalteinheit direkt auf die Emitterplatte der unmittelbar benachbarten Schaltungseinheiten in Kontakt sein, wobei die Schaltungseinheiten über Spannungsmittel miteinander verspannt sind. Somit ist zwischen den Schaltungseinheiten der Reihenschaltung ein Druckkontakt bereitgestellt. Der Potenzialpunkt zwischen zwei Reihenschaltungen von Schaltungseinheiten ist wieder mit einer Anschlussklemme des Submoduls verbunden.

Gemäß einer weiteren Variante der Erfindung sind für jede Schaltungseinheit Kurzschlussmittel vorgesehen, die zum Kurzschließen der Emitterplatte und der Kollektorplatte im Fehlerfall eingerichtet sind. Mit Hilfe der Kurzschlussmittel ist der Schutz des steuerbaren Leistungshalbleiterschalters noch vergrößert.

Vorteilhafterweise weisen die Kurzschlussmittel neben zweckmäßigen Auslösemitteln einen Überbrückungsschalter auf. Der Überbrückungsschalter überbrückt im geschlossenen Zustand Emitterplatte und Kollektorplatte. Als Überbrückungsschalter kommt ein mechanischer Schalter oder ein elektrischer Schalter, wie beispielsweise ein Thyristor, in Betracht. Als mechanischer Schalter dient beispielsweise ein Schalter mit pyrotechnischem oder elektromagnetischem Antrieb. Die Zündung oder Auslösung des Überbrückungsschalters erfolgt durch geeignete Auslösemittel. Beispielsweise detektieren die Auslösemittel eine unsymmetrische Stromverteilung im Leistungshalbleiterschalter in Folge der Beschädigung von Leistungshalbleiterchips.

Vorteilhafterweise sind die Kurzschlussmittel zwischen der Emitterplatte und der Kollektorplatte angeordnet. Hierbei bilden Emitterplatte und Kollektorplatte beispielsweise ein Schaltungsgehäuse aus, wobei die Kurzschlussmittel zumindest teilweise in dem Schaltungsgehäuse angeordnet sind. Das Schaltungsgehäuse stellt einen Schutz vor Verunreinigungen und im Bedarfsfall auch gegenüber Explosionen im Inneren des Schaltungsgehäuses bereit. Beispielsweise sind die Auslösemittel innerhalb des Schaltungsgehäuses angeordnet, während der Überbrückungsschalter außerhalb des Schaltungsgehäuses angeordnet ist. Abweichend hiervon ist auch der Kurzschlussschalter innerhalb des Schaltungsgehäuses angeordnet. Das Schaltungsgehäuse kann gemäß einer weiteren Variante gasdicht ausgebildet und mit einem Schutzgas befüllt sein. Dies verringert die einzuhaltenden Kontaktabstände des mechanischen Schalters und führt zu einem schnelleren Schließen des Schalters.

Gemäß einer bevorzugten Variante ist jeder Leistungshalbleiterschalter einer Schaltungseinheit mit wenigstens zwei parallel zueinander geschalteten Leistungshalbleitersegmenten ausgestattet, die jeweils zwei Lastanschlüsse in Gestalt eines Kollektors oder Emitteranschlusses aufweisen, wobei die Kurzschlussmittel zur Erfassung einer unsymmetrischen Verteilung des Stromes auf die Lastanschlüsse des zugeordneten Leistungshalbleiterschalters aufweisen. Gemäß dieser Variante der Erfindung sind die Auslösemittel zum Auslösen des Schalters durch Mittel zur Erfassung einer unsymmetrischen Verteilung des Stromes auf die Lastanschlüsse des Leistungshalbleiterschalters realisiert. Hierdurch ist eine einfache Fehlererfassung auch bei in Reihe geschalteten Leistungshalbleiterschaltern möglich, so dass eine gezielte Überbrückung der fehlerhaften Leistungshalbleiterschalter der Reihenschaltung, also im Stapel, ermöglicht ist. Darüber hinaus ist eine Erfassungs- und Auslösevorrichtung bereitgestellt, die keine eigene Energieversorgung benötigt oder jedenfalls mit sehr geringen Leistungen auskommt, um die zur Fehlerüberwachung notwendigen Bauteile mit Energie zu versorgen. Die Leistungshalbleitersegmente jedes Leistungshalbleiterschalters des Submoduls bilden parallel zueinander geschaltete und weitgehend unabhängige Strompfade aus. Dabei verfügt jedes Leistungshalbleitersegment über seine eigenen zwei Lastanschlüsse, nämlich den Kollektoranschluss sowie den Emitteranschluss, wobei die Emitter- oder bevorzugt die Kollektoranschlüsse elektrisch miteinander verbunden sein können und einen gemeinsamen Lastanschluss ausbilden. In diesem Falle sind die Mittel zur Erfassung einer unsymmetrischen Verteilung des Stromes an den nicht elektrisch miteinander verbundenen Lastanschlüssen angeordnet.

Vorteilhafterweise weisen die Mittel zur Erfassung einer unsymmetrischen Stromverteilung Messsensoren auf, die zur Erfassung eines Stromflusses über wenigstens zwei Lastanschlüsse oder zur Erfassung einer aus dem besagten Stromfluss abgeleiteten Größe eingerichtet sind. Die Messsensoren sind beispielsweise einem Lastanschluss zugeordnet, wobei sie den Stromfluss in der Zuleitung des besagten Lastanschlusses erfassen und diesen mit dem Stromfluss in einem anderen Lastanschluss vergleichen. Sind die beiden erfassten Stromflüsse ungleich, kann auf einen Fehler des Leistungshalbleiterschalters geschlossen werden. Somit verfügen wenigstens zwei Leistungshalbleitersegmente über wenigstens einen Messsensor, der diesem Segment fest zugeordnet ist. Die Messsignale der Messsensoren der Emitter- oder Kollektoranschlüsse werden miteinander verglichen, wobei im Falle des Auftretens einer Unsymmetrie oder einer Unsymmetrie, die einen zuvor festgelegten Schwellenwert überschreitet, auf das Vorliegen eines Fehlers geschlossen und anschließend beispielsweise einen Bypass-Schalter zum Überbrücken des jeweiligen Leistungshalbleiterschalters geschlossen wird.

Zweckmäßigerweise entspricht die Anzahl der Messsensoren einer geraden ganzen Zahl, wobei die Messsensoren in zwei Hälften aufgeteilt und die Signale der Messsensoren der einen Hälfte mit entgegengesetzten Vorzeichen den Signalen der Messsensoren der anderen Hälfte aufaddiert werden. Mit dieser vorteilhaften Ausgestaltung der Erfindung vereinfacht sich der für die Auswertung erforderliche Aufwand mit noch geringeren Kosten im Gefolge. Gemäß dieser vorteilhaften Ausgestaltung kommt es bei einer symmetrischen Stromverteilung auf die Leistungshalbleitersegmente und somit auf die einzelnen Lastanschlüsse zu einer Addition der Messsignale zu null. Übersteigt hingegen die Summe der Messsignale der Messsensoren einen zuvor festgelegten Schwellenwert, kann auf das Vorliegen eines Leistungshalbleiterfehlers geschlossen werden. Die Aufaddierung der Messsensorsignale kann beispielsweise durch zweckmäßige Verschaltung der Messsensoren erzielt werden, wobei der Schwellenwert durch eine Auslösemechanik in die Praxis umgesetzt wird, die über eine gewisse Ansprechträgheit verfügt. Die Verschaltung, also beispielsweise Parallel- oder Reihenschaltung der Messsensoren, ist von der Art der eingesetzten Messsensoren abhängig. Das unterschiedliche Vorzeichen der Messsignale kann durch unterschiedliche Wicklungsrichtungen in den Messspulen der Messsensoren erreicht werden.

Vorteilhafterweise ist an jedem Kollektoranschluss und/oder an jedem Emitteranschluss ein Messsensor angeordnet. Beispielsweise sind 2n Leistungshalbleitersegmente in dem Leistungshalbleiterschalter ausgebildet, wobei n eine ganze Zahl ist. Bei vier Leistungshalbleitersegmenten werden beispielsweise die Kollektoranschlüsse mit jeweils einem Messsensor ausgerüstet, wobei die jeweiligen Messsignale mit unterschiedlichen Vorzeichen aufsummiert werden. Dies kann auch parallel dazu an dem jeweiligen Emitteranschluss erfolgen, wobei die Messsignale der Messsensoren mit gegensinnigen Vorzeichen aufaddiert werden, die an den beiden Emitteranschlüssen angeordnet sind. Abweichend hiervon ist es jedoch auch möglich, jeweils einen Messsensor an dem Kollektoranschluss des einen Leistungshalbleitersegments und an dem Kollektoranschluss des anderen Leistungshalbleitersegments anzuordnen, wobei die Messsignale der beiden Messsensoren mit unterschiedlichen Vorzeichen einander aufsummiert werden.

Gemäß einer weiteren Variante der Erfindung umfassen die Mittel zur Erfassung einer unsymmetrischen Stromverteilung ein weichmagnetisches Joch und wenigstens einen Messsensor, der zum Erfassen eines magnetischen Feldes in dem weichmagnetischen Joch eingerichtet ist. Gemäß dieser vorteilhaften Weiterentwicklung wird ein weichmagnetisches Joch eingesetzt, um eine von Stromflüssen abgeleitete Größe, in diesem Fall ein magnetisches Feld, zu bündeln. Diese Bündelung verringert den messtechnischen Aufwand. Dabei umschließt das weichmagnetische Joch zweckmäßigerweise ein oder mehrere Paare von Lastanschlüssen in der Weise, dass bei einer symmetrischen Stromverteilung auf die von dem weichmagnetischen Joch umschlossenen Lastanschlüsse, die sich im weichmagnetischen Joch einstellenden Magnetfelder jedenfalls in einem messtechnisch überwachten Abschnitt des Jochs gegenseitig auslöschen. Erst bei einer asymmetrischen oder mit anderen Worten unsymmetrischen Stromverteilung kommt es zu einem Ansteigen des Magnetfeldes im weichmagnetischen Joch oder in dessen überwachtem Abschnitt. Das Magnetfeld ist eine nachweisbare Größe, die beispielsweise von einer einzigen Messspule eines Messsensors, die um einen Schenkel des weichmagnetischen Jochs gewickelt ist, erfasst werden kann. Da nicht mehrere Messsensoren, sondern nur noch ein Messsensor benötigt wird, sind die Kosten des Submoduls verringert.

Zweckmäßigerweise umgibt das weichmagnetische Joch Lastanschlüsse des zugeordneten Leistungshalbleiterschalters paarweise. Beispielsweise umgibt das Joch einen Kollektoranschluss des einen Leistungshalbleitersegments sowie einen Emitteranschluss des anderen Leistungshalbleitersegments. Abweichend davon umfasst das weichmagnetische Joch zwei Emitteranschlüsse paralleler Leistungshalbleitersegmente sowie zwei Kollektoranschlüsse von anderen parallelen Leistungshalbleitersegmenten. Es ist in diesem Zusammenhang auch möglich, dass das weichmagnetische Joch vier Emitteranschlüsse von vier Leistungshalbleitersegmenten umschließt. Selbstverständlich können auch Zwischenstege an dem weichmagnetischen Joch ausgebildet sein, so dass jeweils zwei Kollektor- oder Emitteranschlüsse des Leistungshalbleiterschalters von den gleichen Schenkeln des weichmagnetischen Jochs umschlossen sind. Bei dieser Variante löschen sich die Magnetfelder bei Normalbetrieb nur in dem Verbindungssteg gegenseitig aus. An dem Verbindungssteg ist der Messsensor angeordnet.

Zweckmäßigerweise ist wenigstens ein Halbleiterbauelement mit einer Kühlung ausgerüstet. Als Kühlung eignet sich beispielsweise eine Wasserkühlung, die einen Kühlkreislauf mit einem Wärmetauscher aufweist. In dem Kühlkreislauf wird eine Kühlflüssigkeit, wie beispielsweise deionisiertes Wasser, umgewälzt. Die Kühlung führt die Wärme ab, die durch den Betriebsstrom erzeugt wird, der über das Halbleiterelement fließt, nachdem dieses durchlegiert ist.

Weitere zweckmäßige Ausgestaltungen und Vorteile der Erfindung sind Gegenstand der nachfolgenden Beschreibung von Ausführungsbeispielen der Erfindung unter Bezug auf die Figuren der Zeichnung, wobei gleiche Bezugszeichen auf gleich wirkende Bauteile verweisen und wobei
- Figur 1: einen industrieüblichen Leistungshalbleiterschalter gemäß dem Stand der Technik,
- Figur 2: die Anbindung eines Leistungshalbleiterchips in dem Leistungshalbleiterschalter gemäß Figur 1,
- Figur 3: den Aufbau eines druckkontaktierten IGBT-Schalters gemäß dem Stand der Technik,
- Figur 4: ein Ersatzschaltbild eines aus der Praxis bekannten Submoduls,
- Figur 5: ein Ersatzschaltbild eines aus der Praxis bekannten Submoduls,
- Figur 6: ein Ersatzschaltbild eines Ausführungsbeispiels des erfindungsgemäßen Submoduls,
- Figur 7: das Ersatzschaltbild eines weiteren Ausführungsbeispiels des erfindungsgemäßen Submoduls,
- Figur 8: ein Ersatzschaltbild eines weiteren Ausführungsbeispiels des erfindungsgemäßen Submoduls,
- Figur 9: eine Schaltungseinheit eines erfindungsgemäßen Submoduls in einer geschnittenen Seitenansicht,
- Figur 10: eine weitere mögliche Schaltungseinheit in einer Seitenansicht,
- Figur 11: eine mögliche Schaltungseinheit für ein erfindungsgemäßes Submodul in einer Draufsicht,
- Figur 12: eine Reihenschaltung von Schaltungseinheiten, die für den Aufbau eines erfindungsgemäßen Submoduls geeignet ist,
- Figur 13: eine weitere mögliche Ausgestaltung einer Schaltungseinheit für ein erfindungsgemäßes Submodul und
- Figur 14: einen Leistungshalbleiterschalter zeigen, der für einen Einsatz in einer Schaltungseinheit für ein Ausführungsbeispiel des erfindungsgemäßen Submoduls besonders geeignet ist.

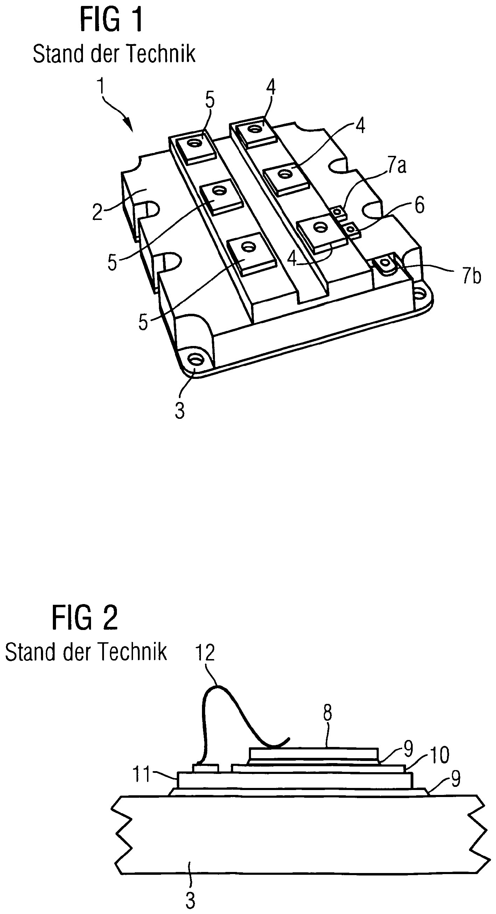

Figur 1 zeigt einen Leistungshalbleiterschalter 1 gemäß dem Stand der Technik in perspektivischer Ansicht, der auch als Leistungshalbleitermodul bezeichnet wird. Es ist erkennbar, dass der Leistungshalbleiterschalter 1 ein Halbleitergehäuse 2 aufweist, das aus einem nicht leitenden isolierenden Material besteht und mit einer metallischen Basisplatte 3 verbunden ist. An seiner Oberseite weist der Leistungshalbleiterschalter 1 drei Emitteranschlüsse 4 sowie drei Kollektoranschlüsse 5 auf, die aus dem Halbleitergehäuse 2 herausgeführt sind. Zur Ansteuerung dient ein so genannter Gate- oder Steueranschluss 6. Ferner ist ein Hilfsemitteranschluss 7a erkennbar, mit welchem dem Steueranschluss 6 das zweckmäßige elektrische Potenzial aufgeprägt werden kann. Ein Hilfskollektoranschluss ist mit 7b referenziert. Selbstverständlich ist es möglich, dass der mit dem Bezugszeichen 4 versehene Lastanschluss den Kollektoranschluss und der mit dem Bezugszeichen 5 versehene Lastanschluss 5 den Emitteranschluss ausbildet.

Innerhalb des Halbleitergehäuse 2 sind Leistungshalbleiterchips beispielsweise IGBT-(Insulated-Gate Bipolar Transistor)-Chips angeordnet, die ebenfalls Stand der Technik und in Figur 2 verdeutlicht sind.

Die Figur 2 zeigt in einer Seitenansicht schematisch einen IGBT-Chip 8 des Leistungshalbleiterschalters 1 gemäß Figur 1, der über eine Lötverbindung 9 mit einer leitenden Kupferschicht 10 verbunden ist, die auf einem nichtleitenden Substrat 11, beispielsweise aus einer zweckmäßigen Keramik, aufgebracht ist. Das Substrat 11 ist mechanisch über eine weitere Lötverbindung 9 mit der Basisplatte 3 verbunden. Zur elektrischen Verbindung mit weiteren Leistungshalbleiterchips 8 dienen Bonddrähte 12, von denen in Figur 2 aus Gründen der Übersichtlichkeit lediglich einer gezeigt ist. Die Bonddrähte 12 sind in dem gezeigten Ausführungsbeispiel mit der Emitterseite des IGBT-Chips 8 als Chiplastanschluss verbunden. Es ist ferner erkennbar, dass die Kupferschicht 10 Leiterbahnen ausbildet, mit denen eine zweckmäßige Verschaltung der IGBT-Chips 8 u. a. mittels der Bonddrähte 12 ermöglicht ist. Die Bonddrähte dienen somit zur Verbindung der Chiplastanschlüsse.

Der in Figur 1 gezeigte Leistungshalbleiterschalter 1 weist insgesamt 24 IGBT-Chips gemäß Figur 2 sowie zwölf diesbezüglich gegensinnig parallel geschaltete Diodenchips auf, die alle in dem Gehäuse 2 untergebracht sind. Alternativ hierzu können auch 18 IGBT-Chips und 18 Diodenchips verbaut sein. Als weitere Alternative können 36 rückwärts leitende IGBT-Chips in dem Gehäuse untergebracht sein, wobei eine gegensinnig parallele Diode und der IGBT-Chip in einem Chip integriert sind. Diese Leistungshalbleiterchips 8 sind in drei voneinander weitgehend unabhängig parallel geschalteten Leistungshalbleitersegmenten angeordnet, so dass ein Leistungshalbleitersegment über jeweils acht IGBT-Chips und vier Dioden-Chips verfügt. Die Lastanschlüsse dieser drei Leistungshalbleitersegmente, also drei Emitteranschlüsse 4 sowie drei Kollektoranschlüsse 5 sind einzeln aus dem Halbleitergehäuse 2 herausgeführt und somit einzeln kontaktierbar. Gemäß dem Stand er Technik sind die Lastanschlüsse an der gleichen Gehäuseseite angeordnet. Während des Normalbetriebs teilt sich der gesamte über den Leistungshalbleiterschalter 1 fließende Strom in etwa gleich auf die drei Leistungshalbleitersegmente mit ihrem jeweiligen Emitter- 4 und Kollektoranschluss 5 auf. Mit anderen Worten führt der Zuleiter eines jeden Kollektoranschlusses 5 bzw. der Zuleiter eines jeden Emitteranschlusses 4 in etwa den gleichen Strom.

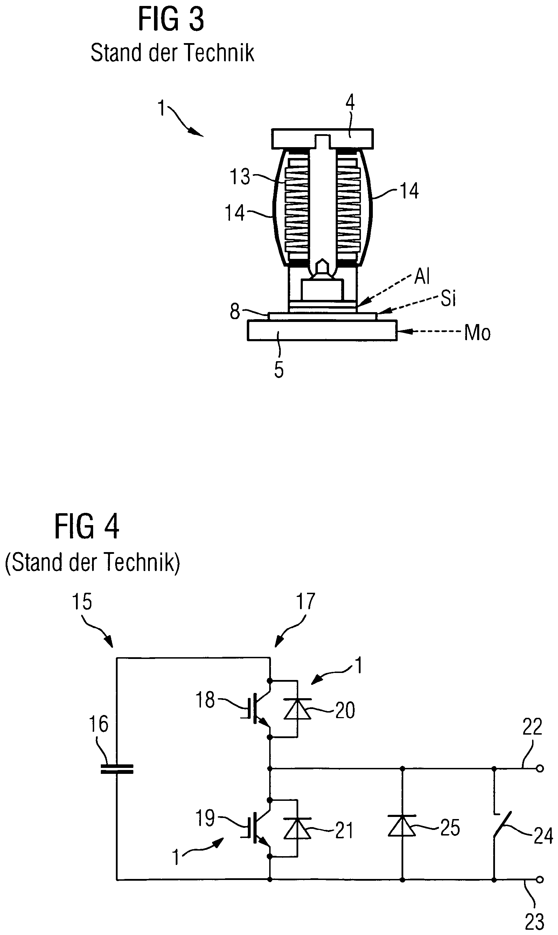

Figur 3 zeigt einen IGBT-Chip 8 eines vorbekannten druckkontaktierten Leistungshalbleiterschalters 1, der die eingangs erwähnte "Conduct on Fail"-Eigenschaft aufweist. Der in Figur 3 gezeigte Leistungshalbleiterschalter 1 ist ebenfalls in Segmente unterteilt, wobei jedes Segment über einen Emitteranschluss 4 sowie über einen Kollektoranschluss 5 verfügt. Im Gegensatz zur Modulbauweise weist ein "Press-pack" gemäß Figur 3 auf der Emitterseite jedoch keine Bonddrähte zur Verbindung der Lastanschlüsse der IGBT-Chips 8 auf. An ihrer Emitterseite sind die Leistungshalbleiterchips 8 über ein Federelement 13 mit Druck beaufschlagt, so dass emitterseitig ein Druckkontakt bereit gestellt ist. Kollektorseitig sind die IGBT-Chips beispielsweise gelötet. Die elektrisch leitende Verbindung mit dem Emitteranschluss 4 wird über einen flexiblen Bandleiter 14 bereitgestellt, mit dem das Federelement 13 elektrisch überbrückt ist. Im Fehlerfall wird der Leistungshalbleiterchip 8 leitend, so dass die gewünschte "Conduct on Fail"-Eigenschaft bereitgestellt ist. Bei einer Reihenschaltung solcher Press-Packs gemäß Figur 3 führt der Ausfall eines Leistungshalbleiterschalters 1 nicht dazu, dass die gesamte Reihenschaltung ihren Betrieb nicht mehr fortsetzen kann. Vielmehr übernehmen die mit dem fehlerhaften Leistungshalbleiterschalter 1 in Reihe geschalteten Leistungshalbleiterschalter 1 die Funktion, die der fehlerhafte Leistungshalbleiterschalter bisher ausgefüllt hatte, wobei die Bandleiter 14 des defekten Chips in der Lage sind, den gesamten Laststrom zu führen. Bei turnusmäßig stattfindenden Wartungsarbeiten kann der fehlerhafte Leistungshalbeiterschalter 1 schließlich ausgetauscht werden.

Figur 4 zeigt ein Ersatzschaltbild eines aus der Praxis bekannt gewordenen Submoduls. Es ist erkennbar, dass das Submodul eine so genannte Halbbrückenschaltung ausbildet. Hierbei ist einem Energiespeicher 16 eine Reihenschaltung 17 parallel geschaltet, die aus zwei Leistungshalbleiterschaltern 18 und 19 besteht, wobei jedem der Leistungshalbleiterschalter 18 und 19 jeweils eine Freilaufdiode 20 und 21 gegensinnig parallel geschaltet ist. Der Leistungshalbleiterschalter 18 und die Freilaufdiode 20 beziehungsweise 19 und 21 bilden einen Leistungshalbleiterschalter 1 gemäß Figur 1 aus und sind jeweils in einem gemeinsamen Halbleitergehäuse 2 angeordnet. An dem Potenzialpunkt zwischen den Leistungshalbleiterschaltern 18 und 19 beziehungsweise zwischen den Freilaufdioden 20 und 21 ist eine erste Anschlussklemme 22 angeschlossen. Eine zweite Anschlussklemme 23 ist mit einer Klemme des Energiespeichers 16 direkt verbunden. Während des Betriebs ist der Energiespeicher 16, der bevorzugt als Speicherkondensator realisiert ist, geladen, so dass an ihm eine Energiespeicherspannung U_{c} abfällt. Je nach Ansteuerung der steuerbaren Leistungshalbleiterschalter 18 und 19 ist somit entweder die an dem Energiespeicher 16 abfallende Spannung oder aber eine Nullspannung an den Anschlussklemmen 22 und 23 erzeugbar. Eine Reihenschaltung solcher Submodule kann somit als Spannungsquelle gesehen werden, deren Ausgangs- oder Gesamtspannung stufenweise verändert werden kann.

Reihenschaltungen solcher Submodule werden in so genannten Mehrpunkt-Umrichter eingesetzt. Mehrpunkt-Umrichter sind dem Fachmann bekannt, so dass hier auf deren Topologie nicht genauer eingegangen zu werden braucht. Es sei lediglich darauf hingewiesen, dass Mehrpunkt-Umrichter in der englischsprachigen Literatur als "Multi-Level-Converter" oder auch als "Modular Multi-Level-Converter (MMC)" bezeichnet werden. Ein MMC besteht aus so genannten Phasenmodulen, die im Wesentlichen aus einer Reihenschaltung der besagten Submodule bestehen. Die Submodule bilden eine Graetz-Brücke aus (6-Puls-Brücke). Die Anzahl der Phasenmodule entspricht der Anzahl der Phasen des Wechselspannungsnetzes. Dabei erstreckt sich ein Phasenmodul zwischen zwei Gleichspannungsanschlüssen für die Pole eines Gleichspannungszwischenkreises. Ferner ist jedes Phasenmodul mit einem Wechselspannungsanschluss ausgerüstet, der zum Anschluss an eine Phase eines Wechselspannungsnetzes dient. Zwei oder mehrere jeweils an einem Wechselspannungsnetz angeschlossene MMCs, die über einen Gleichspannungszwischenkreis beziehungsweise ein Gleichspannungsnetz miteinander verbunden sind, werden als Hochspannungsgleichstromübertragungs(HGÜ)-Anlage bezeichnet.

Der Ausfall eines Leistungshalbleiterschalters oder der dazu gehörigen Elektronik darf aufgrund von Verfügbarkeitsanforderungen nicht zu einer Abschaltung des gesamten MMCs oder der gesamten HGÜ-Anlage führen. Um nach Ausfall eines Leistungshalbleiterschalters 18 oder 19 einen niederohmigen Strompfad zur Verfügung zu stellen, sind die Anschlussklemmen 22 und 23 durch einen Bypass-Schalter 24 überbrückbar. Die Auslösung des Bypass-Schalters 24 erfolgt über eine Detektion des Überschreitens eines Spannungsniveaus oder eines Gradienten der Spannung oder Stromes am Energiespeicher 16. Hierzu ist jedoch eine relativ aufwändige Energieversorgung für die Überwachungselektronik erforderlich, die das notwendige Auslössignal für den Bypass-Schalter 24 bereitstellt. Als Bypass-Schalter 24 eignet sich beispielsweise ein pyrotechnisch angetriebener mechanischer Schalter. Das überbrückte fehlerhafte Submodul kann bei den nächsten Wartungsarbeiten ausgetauscht werden.

Bei einem Kurzschluss im Gleichspannungszwischenkreis der HGÜ-Anlage kommt zu einem über die Freilaufdiode 21 führenden Kurzschlussstrom, der von dem angeschlossenen Wechselspannungsnetz getrieben wird. Um ein Zerstören der Freilaufdiode 21 zu vermeiden, ist dieser ein Parallelschutzthyristor 25 wechselspannungsseitig parallel geschaltet. Mit anderen Worten ist der Parallelschutzthyristor 25 zwischen der ersten 22 und der zweiten Anschlussklemme 23 angeordnet. Der Parallelschutzthyristor 25 kann die Freilaufdiode 21 schnell, also bereits nach wenigen Mikrosekunden, entlasten.

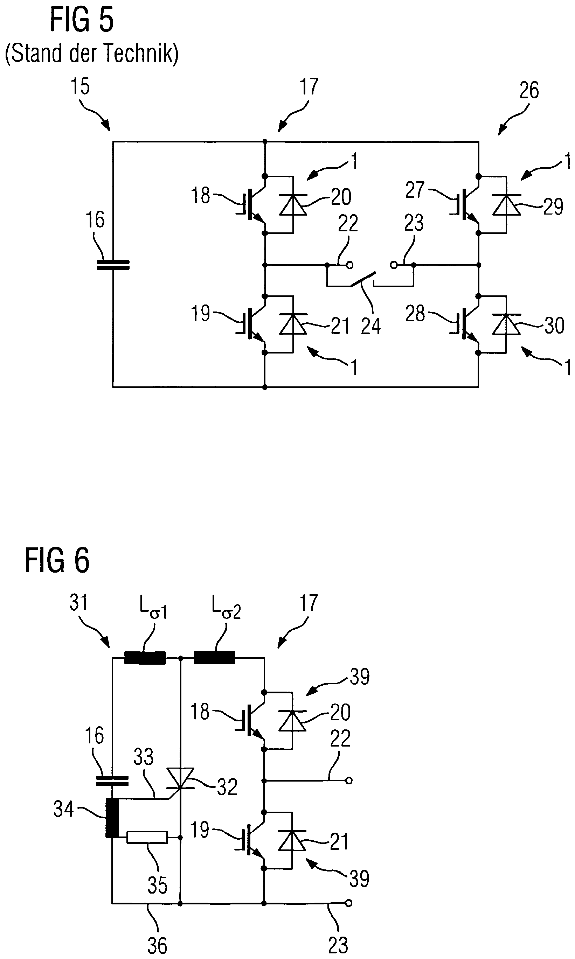

Figur 5 zeigt ein weiteres aus der Praxis bekanntes Ausführungsbeispiel eines Submoduls 15, das in dem gezeigten Fall als Vollbrückenschaltung ausgebildet ist. Die Vollbrückenschaltung unterscheidet sich von der in Figur 4 gezeigten Halbbrückenschaltung dadurch, dass eine zweite Reihenschaltung 26 von Leistungshalbleiterschaltern 27 und 28 vorgesehen ist, wobei den besagten Leistungshalbleiterschaltern 27, 28 wieder jeweils eine Freilaufdiode 29 beziehungsweise 30 gegensinnig parallel geschaltet ist. Die zweite Anschlussklemme 23 ist nun nicht mehr direkt oder unmittelbar mit einem Pol des Energiespeichers 16 verbunden. Vielmehr ist auch die zweite Anschlussklemme 23 an den Potenzialpunkt zwischen zwei Leistungshalbleiterschaltern 27 und 28 angeschlossen. An der ersten und der zweiten Anschlussklemme kann nun je nach Ansteuerung der Leistungshalbleiterschalter 18, 19, 27 und 28 entweder die an dem Energiespeicher 16 abfallende Energiespeicherspannung, die inverse Energiespeicherspannung oder aber eine Nullspannung erzeugt werden. Für die Hochspannungsgleichstromübertragung weist die Vollbrückenschaltung den Vorteil auf, dass bei einem gleichspannungsseitigen Kurzschluss der Kurzschlussstrom nicht ungehindert über Freilaufdioden fließen kann. Gleichspannungsseitige Kurzschlüsse können mit der Vollbrückenschaltung besser beherrscht werden. Nachteilig ist jedoch, dass die Vollbrückenschaltung doppelt so viele Leistungshalbleiterschalter benötigt, wie die Halbbrückenschaltung. Dies wirkt sich auch nachteilig auf die sich einstellenden Verluste aus. Ein Parallelschutzthyristor 25 ist jedoch bei einer Vollbrückenschaltung nicht mehr erforderlich.

Wie bereits ausgeführt wurde, ist im Fehlerfall der Bypass-Schalter 24 zu schließen, um das Herunterfahren der gesamten HGÜ-Anlage zu vermeiden. Der Kurzschlussschalter 24 ist zum Führen des Betriebsstromes eingerichtet. Vom Auftreten und dem Nachweis des Fehlerfalls bis zum Schließen des mechanischen Bypass-Schalters 24 vergehen in der Regel bis zu 1 Millisekunde. In dieser Zeitspanne fließen hohe Kurzschlussströme über die Leistungshalbleiterchips der Leistungshalbleiter 18, 19, 20 und 21 beziehungsweise 27, 28, 29 und 30. Die hohen Ströme führen zunächst zum Ausfall zunächst eines Chips, wobei sich anschließend der gesamte Laststrom auf diesen ausgefallenen Chip konzentriert. Die mit diesem ausgefallenen Chip verbundenen Bonddrähte werden durch den Laststrom überlastet, so dass diese Schmelzen und aufgrund hoher magnetischer Kräfte herausgerissen werden. Dies führt zu der Ausbildung eines Lichtbogens und damit der Explosion des gesamten Leistungshalbleiterschalters. Die Leistungshalbleiterschalter 18, 19, 20, 21, 27, 28, 29 und 30 sind daher gemäß dem Stand der Technik in einem explosionsfesten Submodulgehäuse angeordnet, das eine unkontrollierte Ausbreitung der Explosionsgase und somit eine Zerstörung des MMCs verhindert.

Figur 6 zeigt ein Ausführungsbeispiel des erfindungsgemäßen Submoduls 31, das wieder als Halbbrückenschaltung aufgebaut ist und somit weitestgehend dem in Figur 4 gezeigten Submodul 15 entspricht. Auch hier ist dem Energiespeicher 16 wieder eine Reihenschaltung 17 aus zwei Leistungshalbleiterschaltern 18 und 19 parallel geschaltet, wobei jedem dem Leistungshalbleiterschalter 18, 19 wieder eine Freilaufdiode 20 und 21 gegensinnig parallel geschaltet ist. Darüber hinaus ist jedoch ein Entladethyristor 32 als Halbleiterbauelement vorgesehen, der niederinduktiv dem Energiespeicher 16 parallel geschaltet ist. Der Entladethyristor 32 weist einen Steueranschluss 33 auf, an den Kopplungsmittel angeschlossen sind. Die Kopplungsmittel umfassen eine Spule 34 sowie einen ohmschen Widerstand 35. Dabei umgibt die Spule einen Verbindungsleiter 36, der eine elektrische Verbindung des Energiespeichers 16 mit der Halbleiterschaltung in Gestalt der Reihenschaltung 17 bereitstellt. In Figur 6 sind ferner schematisch Induktivitäten verdeutlicht, welche die Induktivität L 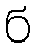 1 des ersten Stromkreises, der von dem Energiespeicher 16 über den Entladethyristor 32 führt, und die Induktivität L 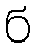 2 eines zweiten Stromkreises verdeutlichen, der von dem Energiespeicher 16 über die Reihenschaltung 17 führt. Mit dem Begriff niederinduktive Anbindung ist im Rahmen der Erfindung gemeint, dass die Induktivität L 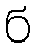 1 des über den Entladethyristor 32 führenden Stromkreises geringer ist als die Induktivität L 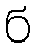 2 des Stromkreises, der über die Reihenschaltung 17 führt.

Im Gegensatz zu dem in Figur 4 gezeigten Ausführungsbeispiel sind die Freilaufdioden 20 und 21 als separate Freilaufdioden ausgebildet, die nicht gemeinsam mit den ansteuerbaren Leistungshalbleiterchips der Leistungshalbleiterschalter 18 und 19 in einem Gehäuse angeordnet sind. Die Freilaufdioden 20 und 21 sind als externe Scheibenzellendioden ausgebildet. Dabei sind die Scheibenzellendioden 20 und 21 jeweils zwischen einer Kollektorplatte und einer Emitterplatte einer Schaltungseinheit angeordnet und weisen zweckmäßigerweise eine elektrisch leitfähige und elastische Deformationsschicht auf, so dass die Freilaufdioden 20 und 21 durch das Verspannen zwischen Kollektor- und Emitterplatte nicht zerstört werden. Die Deformationsschicht ist elektrisch leitfähig und elastisch. Sie besteht beispielsweise aus Kupfer. Die Emitterplatte ist dabei mit dem Emitteranschluss des zugeordneten Leistungshalbleiterschalters 18 oder 19 verbunden. Die Kollektorplatte ist hingegen an dem Kollektoranschluss des Leistungshalbleiterschalters 18 beziehungsweise 19 angeschlossen. Auf den Aufbau dieser Schaltungseinheit 39 wird später noch genauer eingegangen.

Bei einem Fehler des Leistungshalbleiterschalters 18 beziehungsweise 19 oder seiner Elektronik treten sofort hohe Kurzschlussströme auf, die von dem Energiespeicher 16 getrieben sind. Es kommt daher zu einem schnellen Stromanstieg in der Verbindungsleitung 36. Aufgrund der induktiven Kopplung des Steueranschlusses 33 des Entladethyristors 32 wird an dem Steueranschluss 33 durch den Stromgradienten eine Spannung induziert, die eine Zündung des Entladethyristors 32 bewirkt. Der Entladethyristor 32 wird daher im Fehlerfall in seinen leitfähigen Zustand überführt. Mit anderen Worten wird der Energiespeicher 16 auch durch den Entladethyristor 32 kurzgeschlossen. Aufgrund der niederinduktiven Anbindung fließt nun ein Entladungsstrom im Wesentlichen über den Entladethyristor 32. Bei Spannungen im Bereich von 2 bis 20kV, die an dem Energiespeicher 16 abfallen können, kommt es unmittelbar nach dessen Zündung zu einem sehr starken Stromanstieg auch im Entladethyristor 32, der in Folge dessen durchlegiert und somit in beiden Richtungen leitend wird. Der Entladethyristor 32 übernimmt dann im Wesentlichen den gesamten Entladungsstrom des Energiespeichers 16, wobei die Leistungshalbleiterschalter 18 und 19 vor hohen Strömen geschützt sind. Die Ausbildung eines Lichtbogens unterbleibt. Die Freilaufdioden 20 und 21 sind als Scheibenzellendioden ausgebildet, so dass diese auch bei höheren Kurzschlussströmen nicht zerstört werden. Übersteigt jedoch der über die Freilaufdioden 20 und 21 fließende Strom oder ein Stromanstieg oder ein Spannungsanstieg einen festgelegten Schwellenwert, kann es jedoch trotz des Entladethyristors 32 zu einer Zerstörung der Freilaufdioden 20 und 21 kommen. Auch dies führt im Rahmen der Erfindung jedoch nicht zu einer Lichtbogenbildung oder zu einem Ausfall der Dioden. Vielmehr haftet den Freilaufdioden 20 und 21 aufgrund des Einsatzes von druckkontaktierten Chips eine so genannte Conduct-On-Fail-Eigenschaft an. Mit anderen Worten ist im Rahmen der Erfindung im Fehlerfall ein Stromfluss allein über druckkontaktierte Bauelemente bereitgestellt. Es kommt somit zu einer sicheren Überbrückung des fehlerhaften Submoduls 31 im Fehlerfall. Aufwändige mechanische Schalter zwischen den Anschlussklemmen 22 und 23 sind im Rahmen der Erfindung überflüssig geworden. Dies trifft auch für den in Figur 4 mit 25 bezeichneten Parallelschutzthyristor zum Schutz der Freilaufdiode 21 zu. Diese ist nun als durchlegierende Scheibenzellendiode ausgestaltet, die eine hohe I²t-Festigkeit besitzen.

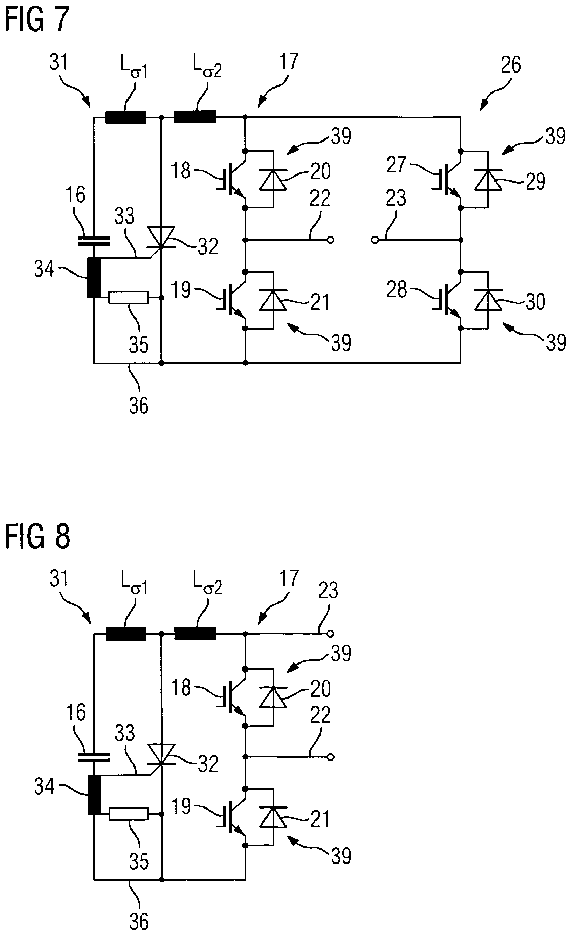

Figur 7 zeigt ein weiteres Ausführungsbeispiel des erfindungsgemäßen Submoduls, das sich von dem in Figur 6 gezeigten Ausführungsbeispiel dadurch unterscheidet, das es als Vollbrückenschaltung gemäß Figur 5 ausgebildet ist. Auch hier sind die Freilaufdioden 20, 21, 29 und 30 wieder als Scheibenzellendioden ausgebildet, die jeweils zwischen einer Emitter- und einer Kollektorplatte einer Schaltungseinheit 39 verspannt sind. Mit Hilfe des Überbrückungs- oder Entladethyristors 32 ist somit im Fehlerfall dafür gesorgt, dass die Leistungshalbleiterschalter 18, 19, 27 und 28 vor hohen Fehlerströmen geschützt sind. Im Fehlerfall ist ein Stromfluss allein über druckkontaktierte Bauelemente in beiden Richtungen über das erfindungsgemäße Submodul möglich.

Um die Betriebsströme auch über längere Zeitdauern sicher führen zu können, ist der Entladethyristor 32 mit einer Kühlung ausgerüstet. Die Kühlung umfasst einen Kühlkreislauf, in dem eine Kühlflüssigkeit, wie deionisiertes Wasser, umgewälzt wird. Ferner ist ein mit dem Kühlkreislauf verbundener Wärmetauscher vorgesehen. Ein gekühlter Entladethyristor ist grundsätzlich in jedem erfindungsgemäßen Submodul einsetzbar. Beispielsweise ist der Entladethyristor 32 des Submoduls gemäß der Figuren 6, 7 oder 8 ein gekühlter Entladethyristor.

Figur 8 zeigt ein weiteres Ausführungsbeispiel des erfindungsgemäßen Submoduls 31, das wie das in Figur 6 gezeigte Submodul 31 als Halbbrückenschaltung ausgebildet ist. Die Halbbrückenschaltung verfügt über einen Energiespeicher 16 und eine einzige Reihenschaltung 17 als Halbleiterschaltung, die dem Energiespeicher 16 parallel geschaltet ist. Die Reihenschaltung 17 ist wieder mit zwei in Reihe geschalteten abschaltbaren Leistungshalbleiterschaltern 18, 19 ausgestattet, denen jeweils zwei separate Scheibenzellendioden 20, 21 gegensinnig parallel geschaltet sind. Die separaten Scheibenzellendioden 20, 21 wirken als Freilaufdioden. Die abschaltbaren Leistungshalbleiterschalter 18, 19 sind als industrieübliche IGBT-Module ausgebildet und verfügen somit über Bonddrähte, die zum Führen des Laststromes des jeweiligen Leistungshalbleiterschalters 18 bzw. 19 dienen. Auch ist der Entladethyristor 32 in Parallelschaltung zum Energiespeicher erkennbar. Der Auslösemechanismus für den Entladethyristor 32 entspricht dem im Zusammenhang mit Figur 6 ausgeführten Auslösemechanismus. Sowohl das Submodul 31 gemäß Figur 6 als auch das Submodul 31 gemäß Figur 8 weisen eine erste Anschlussklemme 22 auf, die mit dem Potentialpunkt zwischen den Leistungshalbleiterschaltern 18 und 19 verbunden ist. Bei beiden Submodulen 31 ist die zweite Anschlussklemme 23 mit einer Klemme oder Pol des Energiespeichers 16 verbunden. Beim Ausführungsbeispiel des Submoduls 31 gemäß Figur 6 ist die zweite Anschlussklemme 23 jedoch direkt mit dem Emitter des Leistungshalbleiterschalters 19 und somit direkt mit dem negativen Pol des Energiespeichers 16 verbunden. Beim Submodul 31 gemäß Figur 8 ist die zweite Anschlussklemme 23 hingegen direkt an den Kollektor des Leistungshalbleiterschalters 18 und somit an den positiven Pol des Energiespeichers 16 angeschlossen. Die Wirkungsweise der in Figur 6 und 8 gezeigten Submodule 31 ist jedoch nahezu identisch. Je nach Schaltzustand der Leistungshalbleiterschalter 18 und 19 kann zwischen der ersten 22 und der zweiten Anschlussklemme 23 die an dem Energiespeicher 16 abfallende Spannung oder aber eine Nullspannung erzeugt werden. Je nach Ausgestaltung der Halbbrückenschaltung wechselt lediglich die Polarität der Anschlussklemmen 22,23 des Submoduls 31.

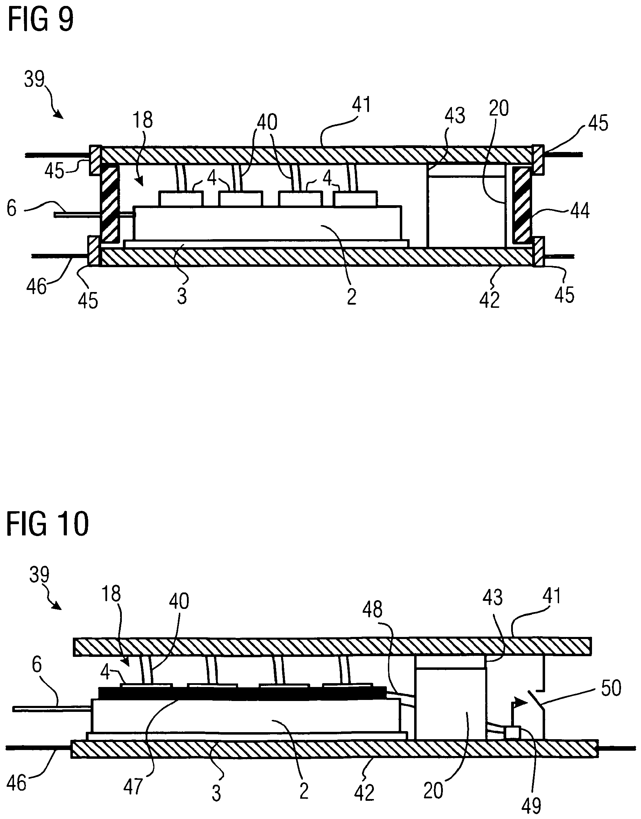

Figur 9 zeigt ein Ausführungsbeispiel einer Schaltungseinheit 39, die einen Leistungshalbleiterschalter 18 sowie eine Freilaufdiode 20 umfasst, die gegensinnig parallel zum Leistungshalbleiterschalter 18 geschaltet ist. Der Leistungshalbleiterschalter 18 ist ähnlich dem in Figur 1 gezeigten Leistungshalbleiterschalter aufgebaut und verfügt über vier parallele Leistungshalbleitersegmente, von denen jedes Leistungshalbleitersegment einen Emitteranschluss 4 und einen in Figur 9 verdeckt angeordneten Kollektoranschluss 5 ausbildet. Die besagten Lastanschlüsse 4, 5 sind aus einem elektrisch nicht leitfähigen Halbleitergehäuse 2 herausgeführt, in dem ausschließlich ansteuerbaren Leistungshalbleiterchips und bevorzugt IGBT-Chips 8 angeordnet sind. Die Chipemitteranschlüsse der Leistungshalbleiterchips 8 sind u. a. über Bonddrähte miteinander verbunden.

Aus Figur 9 ist ferner erkennbar, dass die Emitteranschlüsse 4 über eine Zuleitung oder Verleitungsleitung 40 mit einer Emitterplatte 41 verbunden sind, wohingegen die in Figur 9 nicht erkennbaren Kollektoranschlüsse über entsprechende Verbindungsleitungen mit einer Kollektorplatte 42 elektrisch verbunden sind. Zwischen der Emitterplatte 41 und der Kollektorplatte 42 ist die Freilaufdiode 20 mit einer Deformationsschicht 43 aus Kupfer angeordnet, die eine mechanische Zerstörung der Scheibenzellendioden 20 beim Verspannen zwischen den Platten 41 und 42 verhindert. Darüber hinaus ist eine Seitenwand 44 aus einem nicht leitenden Material erkennbar, deren Höhe etwas geringer ist als die Höhe der Scheibenzellendiode 20 einschließlich der Deformationsschicht 43. Somit wird der beim Verspannen auftretende Druck allein von der Scheibenzellendiode 20 sowie der Deformationsschicht 43 aufgenommen. Die Seitenwand 44 schützt vor Verunreinigungen oder dergleichen. Zum formschlüssigen Halten der Seitenwandung 44 sind formschlüssige Halterungen in Gestalt von Halteschultern 45 erkennbar, die an der Emitterplatte 41 beziehungsweise Kollektorplatte 42 angeordnet sind. Zur Kühlung der IGBT-Chips 8 dienen Kühlrohre 46, die in Bohrungen der Platten 41, 42 münden. Die Kühlrohre 46 sind aus einem nicht leitenden Material hergestellt, wobei deionisiertes Wasser in den Kühlrohren 46 umgewälzt wird. Auf diese Art und Weise ist eine isolierte Kühlung bereitgestellt. Die Kühlrohre 46 erstrecken sich in dem gezeigten Ausführungsbeispiel sowohl bis zur Kollektorplatte 42 als auch bis zur Emitterplatte 41.

Figur 10 zeigt ein weiteres Ausführungsbeispiel einer Schaltungseinheit 39 für ein erfindungsgemäßes Submodul 31 in einer teilweise geschnittenen Seitenansicht. Das in Figur 10 gezeigte Ausführungsbeispiel unterscheidet sich von dem in Figur 9 gezeigten Ausführungsbeispiel dadurch, dass keine isolierende Seitenwandung 44 mehr vorgesehen ist. Vielmehr sind der Leistungshalbleiterschalter 18 und die Freilaufdiode 22 offen zwischen Emitter- 41 und Kollektorplatte 42 angeordnet. Wieder dient die Scheibenzellendiode 20 mit ihrer Deformationsschicht 43 zur Aufnahme des Spannungsdrucks zwischen den besagten Platten 41 und 42. Darüber hinaus sind jedoch Kurzschlussmittel vorgesehen, die ein weichmagnetisches Joch 47 aufweisen, das die vier Emitteranschlüsse 4 geschlossen umgibt. In der Mitte des weichmagnetischen Jochs 47 ist ein hier nicht erkennbarer Verbindungssteg angeordnet, so dass jeweils zwei Emitteranschlüsse von gemeinsamen Schenkeln des Jochs 47 umgeben sind. Um den mittleren Verbindungssteg ist eine Messspule gewickelt, die zum Erfassen eines magnetischen Felds eingerichtet ist. Der Ausgang der Messspule ist direkt mit einer Auslöseeinheit 49 verbunden, die zum Schließen eines mechanischen Schalters 50 eingerichtet ist. Die Auslöseeinheit 49 ist beispielsweise ein pyrotechnischer Antrieb oder ein elektromagnetischer Antrieb. Selbstverständlich ist es auch möglich, den Schalter 50 als elektronischer Schalter auszubilden, wobei die Signalleitung 48 dann zum direkten elektrischen Zünden des Überbrückungsschalters 50 dient. Es ist ferner erkennbar, dass lediglich die Kollektorplatte 42 mit Kühlrohren 46 ausgerüstet ist.

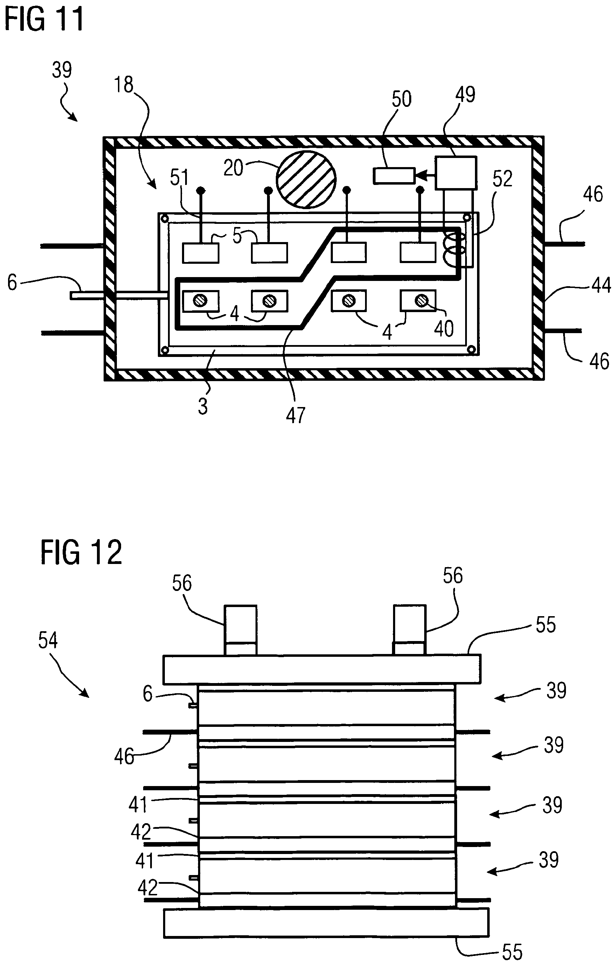

Figur 11 zeigt ein weiteres Ausführungsbeispiel einer Schaltungseinheit 39 für das erfindungsgemäße Submodul 31. Bei der Ausführungsform gemäß Figur 11 ist wieder ein Leistungshalbleiterschalter 18 vorgesehen, dem die Freilaufdiode 20 gegensinnig parallel geschaltet ist. In der gezeigten Draufsicht sind die Kollektoranschlüsse 5 des Leistungshalbleiterschalters 18 zu erkennen, die über die Verbindungsleitungen 51 mit der Kollektorplatte 42 verbunden sind. Es ist ferner erkennbar, dass das weichmagnetische Joch 47 zwei Emitteranschlüsse 4 sowie zwei Kollektoranschlüsse 5 umgibt. Bei Normalbetrieb des Leistungshalbleiterschalters 18 kommt es zu einer symmetrischen Stromverteilung in den Lastanschlüssen 4, 5. Die sich in dem weichmagnetischen Joch 47 einstellenden Magnetfelder löschen sich gegenseitig aus. Eine Messspule 52, welche einen Schenkel des weichmagnetischen Jochs 47 umfasst, kann daher kein magnetisches Feld nachweisen. In einem Fehlerfall kommt es jedoch zu einer Konzentration des Stromflusses in einem der Emitter- 4 oder in einem der Kollektoranschlüsse 5, wodurch eine asymmetrische Stromverteilung ein magnetisches Feld in dem weichmagnetischen Joch 47 erzeugt. Am Ausgang der Messelektrode 52 ist somit ein Auslösesignal erhältlich, das der Auslöseeinheit 49 zugeleitet wird, welche für eine Auslösung des Schalters 50 sorgt. Somit kann im Fehlerfall der Leistungshalbleiterschalter 18 zusätzlich geschützt werden.

Figur 12 zeigt eine Reihenschaltung 54 von Schaltungseinheiten 39, die beispielsweise gemäß Figur 9, 10 oder 11 ausgestaltet sind. Es ist erkennbar, dass die Schaltungseinheit 39 aufeinander gestapelt sind, wobei die Kollektorplatte 42 einer Schaltungseinheit 39 in flächigem Kontakt mit einer Emitterplatte 41 der unmittelbar benachbarten Schaltungseinheit 39 ist. Die Schaltungseinheiten 39 sind somit miteinander druckkontaktiert. Um für einen ausreichend guten Kontakt zu sorgen, sind die Schaltungseinheiten 39 miteinander verspannt. Hierzu dienen zwei Spannplatten 55, die über zweckmäßige Zugmittel 56 miteinander fest verspannt sind. Eine solche Reihenschaltung 54 kann somit anstelle einer einzigen Schaltungseinheit 39 in der Voll- oder Halbbrückenschaltung gemäß Figur 6 oder 7 eingesetzt werden. Die erste Anschlussklemme 22 wäre dann mit einem Potenzialpunkt zwischen zwei Reihenschaltungen 54 gemäß Figur 12 verbunden, wobei die Reihenschaltung 17 gemäß Figur 6 durch zwei Reihenschaltungen 54 gemäß Figur 12 ausgebildet wäre. Die ansteuerbaren Leistungshalbleiterschalter der Schaltungseinheiten 39 der Reihenschaltung 54 werden kann synchron miteinander getaktet und somit angesteuert. Gemäß dieser Ausgestaltung der Erfindung sind größere Spannungen beherrschbar. Es können größere Energiespeicher 16, beispielsweise in Gestalt von Speicherkondensatoren eingesetzt werden, an denen eine höhere Spannung abfällt. So ist beispielsweise eine Schaltungseinheit 39 für Spannungen zwischen 2kV und 4kV ausgelegt. Eine Reihenschaltung von vier Schaltungseinheiten gemäß Figur 12 ist somit zum Schalten von Spannungen in der Größenordnung von beispielsweise 8kV bis 16kV eingerichtet. Die Anzahl der Submodule in einem Phasenmodul einer HGÜ-Anlage ist auf diese Weise verringert.

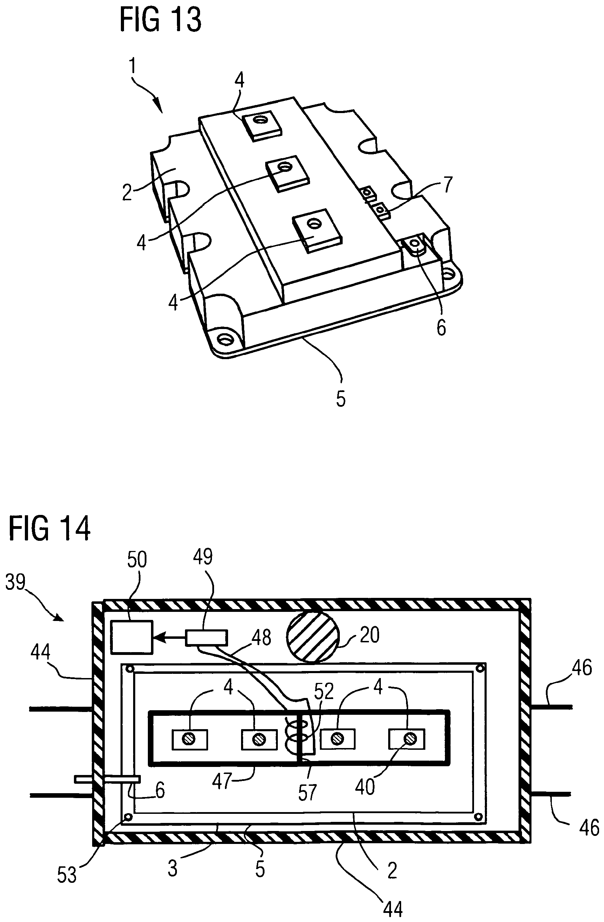

Figur 13 zeigt einen von dem Aufbau des in Figur 1 dargestellten Leistungshalbleiterschalters 1 abweichenden Leistungshalbleiterschalter. Es ist erkennbar, dass der in Figur 13 gezeigte Leistungshalbleiterschalter 18 an seiner Oberseite lediglich drei Emitteranschlüsse 4 aufweist, die aus dem elektrisch nicht leitenden Gehäuse 2 herausgeführt sind. Die Emitteranschlüsse 4, der in dem Halbleitergehäuse 2 angeordneten Leistungshalbleiterchips, sind hingegen in direktem Kontakt mit der Basisplatte 3, die bei dem in Figur 13 gezeigten Leistungshalbleiterschalter 18 daher als Kollektoranschluss 5 dient. Die direkte flächige Anbindung der Chipkollektoranschlüsse erfolgt beispielsweise dadurch, dass die Leistungshalbleiterchips 8, beispielsweise IGBT-Chips 8, nicht auf einer elektrisch isolierenden Keramik aufgelötet sind. Vielmehr ist der Chipkollektoranschluss auf eine metallische Trägerplatte aufgelötet, die wiederum in elektrisch leitendem flächigen Kontakt mit der Basisplatte 3 steht. Eine zusätzliche Verschiebung kann daher entfallen.

Figur 14 zeigt eine Schaltungseinheit für ein erfindungsgemäßes Submodul in einer Draufsicht, wobei ein Leistungshalbleiterschalter 18 gewählt wurde, der gemäß Figur 13 aufgebaut ist. Der in Figur 14 gezeigte Leistungshalbleiterschalter 18 weist jedoch anstatt drei, vier Leistungshalbleitersegmente auf, so dass vier Emitteranschlüsse 4 aus dem Halbleitergehäuse 2 herausgeführt sind. Die Emitteranschlüsse 4 sind wiederum von dem weichmagnetischen Joch 47 umgeben, wobei das weichmagnetische Joch 47 einen mittleren Verbindungssteg 57 ausbildet. Der Verbindungssteg 57 ist mit einer Messspule 52 umwickelt, deren Ausgang über Signalleitungen 48 mit der Auslöseeinheit 49 verbunden ist. Die Auslöseeinheit 49 dient wiederum zum Schalten eines Schalters 50. Gemäß dieser Ausgestaltung der Erfindung ist lediglich in dem Verbindungssteg 57 bei einer symmetrischen Stromverteilung kein Magnetfeld nachweisbar, da sich die Magnetfelder, die sich aufgrund der symmetrischen Stromverteilung auf die Emitteranschlüsse 4 einstellen, sich gegenseitig auslöschen. Bei einer asymmetrischen Stromverteilung, also im Fehlerfall, kommt es jedoch zu einem nachweisbaren Magnetfeld im Verbindungssteg 57 und somit zu einer Auslösung des Schalters 50.

## Patentansprüche

1. Submodul (31) für einen Mehrpunkt-Umrichter mit einem unipolaren Energiespeicher (16), zwei Anschlussklemmen (22,23) und einer Halbleiterschaltung (17,26), die wenigstens zwei ansteuerbare Leistungshalbleiterschalter (18,19,27,28) aufweist, denen jeweils außerhalb des Halbleitergehäuses (2) des Leistungshalbleiterschalters (18,19,27,28) eine separate Freilaufdiode (20,21,29,30) gegensinnig parallel geschaltet ist, wobei dem unipolaren Energiespeicher (16) niederinduktiv wenigstens ein Halbleiterbauelement (32) parallel geschaltet ist, das im Fehlerfall den Energiespeicher (16) überbrückt, wobei jeder Leistungshalbleiterschalter (18,19,27,28) in einem Halbleitergehäuse (2) angeordnete, ausschließlich steuerbare Leistungshalbleiterchips (8) mit Chiplastanschlüssen aufweist, wobei Bonddrähte (12) die Chiplastanschlüsse der Leistungshalbleiterchips (8) miteinander verbinden,
**dadurch gekennzeichnet, dass**
jede Freilaufdiode (20,21,27,28) eine zur Vermeidung von Bonddrähten druckkontaktierte Scheibenzellendiode und Teil einer Schaltungseinheit (39) ist, die eine Emitterplatte (41) sowie eine Kollektorplatte (42) aufweist, zwischen denen die Scheibenzellendiode (20,21,29,30) verspannt ist, wobei die Kollektorplatte (42) mit einem Kollektoranschluss (5) des Leistungshalbleiterschalters (18,19,27,28) und die Emitterplatte (41) mit einem Emitteranschluss (4) des Leistungshalbleiterschalters (18,19,27,28) verbunden ist, welcher der besagten Freilaufdiode (20,21,29,30) parallel geschaltet ist.

2. Submodul (31) nach Anspruch 1,
**dadurch gekennzeichnet, dass**
das Halbleiterbauelement ein Thyristor (32) ist, dessen Steuerungsanschluss (33) mit Mitteln (34,35) zum Erkennen des Fehlerfalls verbunden ist, wobei der Thyristor (32) so ausgelegt ist, dass er nach seiner Zündung aufgrund des sich einstellenden Fehlerstroms zerstört wird und anschließend leitend bleibt.

3. Submodul (31) nach Anspruch 2,
**dadurch gekennzeichnet, dass**
die Mittel zum Erkennen des Fehlerfalls eine Sensorschaltung aufweisen, die zum Erfassen von Überwachungsgrößen des Submoduls in Gestalt einer Spannungsänderung, einer Stromänderung, eines Stromes und/oder einer an dem Energiespeicher abfallende Spannung eingerichtet ist, wobei die Sensorschaltung den Thyristor (32) zündet, wenn die Überwachungsgröße einen zuvor festgelegten Schwellenwert überschreitet.

4. Submodul (31) nach Anspruch 2,
**dadurch gekennzeichnet, dass**
die Mittel zum Erkennen des Fehlerfalls eine Durchbruchdiode aufweisen, an der die an dem Energiespeicher (16) abfallende Spannung abfällt, wobei die Durchbruchdiode mit dem Steuereingang (33) des Thyristors (32) verbunden und so ausgelegt ist, dass sie bei Überschreiten einer zuvor festgelegten Grenzspannung leitend wird.

5. Submodul (31) nach Anspruch 2,
**dadurch gekennzeichnet, dass**
die Mittel zum Erkennen des Fehlerfalls Kopplungsmittel (34) aufweisen, die ausgangsseitig mit dem Steuereingang des Thyristors (32) verbunden sind, wobei die Kopplungsmittel (34) induktiv mit einer Verbindungsleitung (36) gekoppelt sind, die sich zwischen dem Energiespeicher (16) und der Halbleiterschaltung (17,26) erstreckt.

6. Submodul (31) nach einem der vorhergehenden Ansprüche,
**dadurch gekennzeichnet, dass**
die Halbleiterbauelemente einen Thyristor (32) und eine Rückschwingdiode aufweisen, wobei sowohl der Thyristor (32) als auch die Rückschwingdiode dem Energiespeicher (16) niederinduktiv parallel geschaltet sind.

7. Submodul (31) nach einem der vorhergehenden Ansprüche,
**dadurch gekennzeichnet, dass**
jede Schaltungseinheit (39) eine elektrisch isolierende und umfänglich geschlossene Seitenwand (44) aufweist, deren Höhe etwas geringer als die Höhe der Scheibenzellendiode (20,43) ist, wobei Emitterplatte (41), Kollektorplatte (42) und Seitenwand (44) ein Schaltungsgehäuse ausbilden.

8. Submodul (31) nach Anspruch 7,
**dadurch gekennzeichnet, dass**
die Seitenwand (44) formschlüssig von der Emitterplatte (41) und/oder der Kollektorplatte (42) gehalten ist.

9. Submodul (31) nach einem der vorhergehenden Ansprüche,
**dadurch gekennzeichnet, dass** wenigstens ein Halbleiterbauelement (32) mit einer Kühlung ausgestattet ist.

10. Submodul (31) nach einem der vorhergehenden Ansprüche,
**dadurch gekennzeichnet, dass**
die Halbleiterschaltung (17) zusammen mit dem Energiespeicher (16) eine Halbbrückenschaltung ausbildet.

11. Submodul (31) nach einem der vorhergehenden Ansprüche,
**dadurch gekennzeichnet, dass**
die Halbleiterschaltung (17,26) zusammen mit dem Energiespeicher (16) eine Vollbrückenschaltung ausbildet.

12. Submodul (31) nach Anspruch 10 oder 11,
**dadurch gekennzeichnet, dass**
die Halbleiterschaltung (17,26) zwei oder vier Reihenschaltungen (54) von Schaltungseinheiten aufweist.

13. Submodul (31) nach einem der vorhergehenden Ansprüche,
**dadurch gekennzeichnet, dass**
jede Schaltungseinheit (39) mit zusätzlichen Kurzschlussmitteln (47,48,49,50,52,57) ausgerüstet ist, die zum Kurzschließen der Emitterplatte (41) und der Kollektorplatte (42) im Fehlerfall eingerichtet sind.

14. Submodul (31) nach Anspruch 13,
**dadurch gekennzeichnet, dass**
jeder Leistungshalbleiterschalter (18,19,27,28) einer Schaltungseinheit (39) mit wenigstens zwei parallel zueinander geschalteten Leistungshalbleitersegmenten ausgestattet ist, die jeweils zwei Lastanschlüsse in Gestalt eines Kollektor- (5) oder Emitteranschlusses (4) aufweisen, wobei die Kurzschlussmittel Mittel(47,48,52,57) zur Erfassung einer unsymmetrischen Verteilung des Stromes auf die Lastanschlüsse (4,5) des Leistungshalbleiterschalters (18,19,27,28) aufweisen.

15. Submodul (31) nach Anspruch 14,
**dadurch gekennzeichnet, dass**
die Mittel zur Erfassung einer unsymmetrischen Stromverteilung wenigstens einen Messsensor (52) aufweisen, der oder die zur Erfassung eines Stromflusses über wenigstens zwei Lastanschlüsse (4,5) oder zur Erfassung einer aus dem besagten Stromfluss abgeleiten Größe eingerichtet ist/sind.

16. Submodul (31) nach Anspruch 14,
**dadurch gekennzeichnet, dass**
die Mittel zur Erfassung einer unsymmetrischen Stromverteilung ein weichmagnetisches Joch (47) und wenigstens einen Messsensor (52) aufweisen, der zum Erfassen eines magnetischen Feldes in dem weichmagnetischen Joch (47) eingerichtet ist.

17. Submodul (31) nach einem der Ansprüche 14 bis 16,
**dadurch gekennzeichnet, dass**
die Kurzschlussmittel einen Überbrückungsschalter (50) aufweisen, der mit den Mitteln (47,48,52,57) zur Erfassung einer unsymmetrischen Stromverteilung auf eine Weise verbunden ist, dass der Überbrückungsschalter (50) bei Vorliegen einer unsymmetrischen Stromverteilung geschlossen wird.

## Claims

1. Submodule (31) for a multilevel converter having a unipolar energy store (16), two connection terminals (22, 23) and a semiconductor circuit (17, 26), which has at least two actuable power semiconductor switches (18, 19, 27, 28), a separate freewheeling diode (20, 21, 29, 30) outside of the semiconductor housing (2) of the power semiconductor switch (18, 19, 27, 28) being connected in parallel with each of said power semiconductor switches in the opposite direction, wherein at least one semiconductor component (32) is connected in parallel with the unipolar energy store (16) in a low-inductance manner, which semiconductor component bypasses the energy store (16) in the event of a fault, wherein each power semiconductor switch (18, 19, 27, 28) has exclusively controllable power semiconductor chips (8), which are arranged in a semiconductor housing (2) and have chip load terminals, wherein bonding wires (12) connect the chip load terminals of the power semiconductor chips (8) to one another,
**characterized in that**
each freewheeling diode (20, 21, 29, 30) is a disk-cell diode, which is pressure-contact-connected to avoid bonding wires, and part of a circuit unit (39), which has an emitter plate (41) and a collector plate (42), between which the disk-cell diode (20, 21, 29, 30) is braced, wherein the collector plate (42) is connected to a collector terminal (5) of the power semiconductor switch (18, 19, 27, 28) and the emitter plate (41) is connected to an emitter terminal (4) of the power semiconductor switch (18, 19, 27, 28), which is connected in parallel with said freewheeling diode (20, 21, 29, 30).

2. Submodule (31) according to Claim 1,
**characterized in that**
the semiconductor component is a thyristor (32), the control terminal (33) of which is connected to means (34, 35) for identifying the event of a fault, wherein the thyristor (32) is designed so that, after ignition thereof, on account of the fault current produced, it is destroyed and subsequently remains conducting.

3. Submodule (31) according to Claim 2,
**characterized in that**
the means for identifying the event of a fault have a sensor circuit, which is configured to detect monitoring variables of the submodule in the form of a change in voltage, a change in current, a current and/or a voltage dropped across the energy store, wherein the sensor circuit ignites the thyristor (32) when the monitoring variable exceeds a previously determined threshold value.

4. Submodule (31) according to Claim 2,
**characterized in that**
the means for identifying the event of a fault have a breakdown diode, across which the voltage dropped across the energy store (16) is dropped, wherein the breakdown diode is connected to the control input (33) of the thyristor (32) and designed so that it becomes conducting when a previously determined limit voltage is exceeded.

5. Submodule (31) according to Claim 2,
**characterized in that**
the means for identifying the event of a fault have coupling means (34), the output sides of which are connected to the control input of the thyristor (32), wherein the coupling means (34) are coupled inductively to a connecting line (36), which extends between the energy store (16) and the semiconductor circuit (17, 26).

6. Submodule (31) according to one of the preceding claims,
**characterized in that**
the semiconductor components have a thyristor (32) and a ring-back diode, wherein both the thyristor (32) and the ring-back diode are connected in parallel with the energy store (16) in a low-inductance manner.

7. Submodule (31) according to one of the preceding claims,
**characterized in that**
each circuit unit (39) has an electrically isolating and circumferentially closed side wall (44), the height of which is somewhat lower than the height of the disk-cell diode (20, 43), wherein the emitter plate (41), the collector plate (42) and the side wall (44) form a circuit housing.

8. Submodule (31) according to Claim 7,
**characterized in that**
the side wall (44) is held in a form-fitting manner by the emitter plate (41) and/or the collector plate (42).

9. Submodule (31) according to one of the preceding claims,
**characterized in that**
at least one semiconductor component (32) is provided with a cooling system.

10. Submodule (31) according to one of the preceding claims,
**characterized in that**
the semiconductor circuit (17) forms a half-bridge circuit together with the energy store (16).

11. Submodule (31) according to one of the preceding claims,
**characterized in that**
the semiconductor circuit (17, 26) forms a full-bridge circuit together with the energy store (16).

12. Submodule (31) according to Claim 10 or 11,
**characterized in that**
the semiconductor circuit (17, 26) has two or four series circuits (54) of circuit units.

13. Submodule (31) according to one of the preceding claims,
**characterized in that**
each circuit unit (39) is furnished with additional short-circuiting means (47, 48, 49, 50, 52, 57), which are configured to short-circuit the emitter plate (41) and the collector plate (42) in the event of a fault.

14. Submodule (31) according to Claim 13,
**characterized in that**
each power semiconductor switch (18, 19, 27, 28) of a circuit unit (39) is provided with at least two power semiconductor segments connected in parallel with one another, which each have two load terminals in the form of a collector terminal (5) or emitter terminal (4), wherein the short-circuiting means have means (47, 48, 52, 57) for detecting an asymmetrical distribution of the current over the load terminals (4, 5) of the power semiconductor switch (18, 19, 27, 28).

15. Submodule (31) according to Claim 14,
**characterized in that**
the means for detecting an asymmetrical current distribution have at least one measurement sensor (52), which is/are configured to detect a flow of current via at least two load terminals (4, 5) or to detect a variable derived from said flow of current.

16. Submodule (31) according to Claim 14,
**characterized in that**
the means for detecting an asymmetrical current distribution have a soft-magnetic yoke (47) and at least one measurement sensor (52), which is configured to detect a magnetic field in the soft-magnetic yoke (47).

17. Submodule (31) according to one of Claims 14 to 16,
**characterized in that**
the short-circuiting means have a bypass switch (50), which is connected to the means (47, 48, 52, 57) for detecting an asymmetrical current distribution in such a way that the bypass switch (50) is closed when there is an asymmetrical current distribution.

## Revendications

1. Sous-module (31) pour un convertisseur à plusieurs points, comprenant un accumulateur (16) d'énergie unipolaire, deux bornes (22, 23) de connexion et un montage (17, 26) à semi-conducteur, qui a au moins deux interrupteurs (18, 19, 27, 28) à semi-conducteur de puissance pouvant être commandés, avec lesquels est montée, en parallèle tête-bêche respectivement à l'extérieur du boîtier (2) de semi-conducteur de l'interrupteur (18, 19, 27, 28) à semi-conducteur de puissance, une diode (20, 21, 29, 30) de roue libre distincte, dans lequel est monté, en parallèle à l'accumulateur (16) d'énergie unipolaire, à basse induction, au moins un composant (32) à semi-conducteur, qui, en cas de défaut, shunte l'accumulateur (16) d'énergie, chaque interrupteur (18, 19, 27, 28) à semi-conducteur de puissance ayant des puces (8) à semi-conducteur de puissance, disposées dans un boîtier (2) de semi-conducteur, pouvant être commandées exclusivement et ayant des bornes de charge de puce, des fils (12) de liaison des bornes des charge des puces (8) à semi-conducteur de puissance étant reliées entre elles,
**caractérisé en ce que**
chaque diode (20, 21, 27, 28) de roue libre est une diode à cellule à tranche contactée par pression pour se dispenser de fils de liaison et fait partie d'une unité (39) de circuit, qui a une plaque (41) d'émetteur, ainsi qu'une plaque (42) de collecteur entre lesquelles est bloquée la diode (20, 21, 29, 30) à cellule à tranche, la plaque (42) de collecteur étant reliée à une borne (5) de collecteur de l'interrupteur (18, 19, 27, 28) à semi-conducteur de puissance et la plaque (41) d'émetteur à une borne (4) d'émetteur de l'interrupteur (18, 19, 27, 28) à semi-conducteur de puissance, lequel est monté en parallèle à ladite diode (20, 21, 29, 30) de roue libre.

2. Sous-module (31) suivant la revendication 1,
**caractérisé en ce que**
le composant à semi-conducteur est un thyristor (32), dont la borne (33) de commande est reliée à des moyens (34, 35) de détection du cas de défaut, le thyristor (32) étant conçu de manière à être détruit après son amorçage en raison du courant de défaut qui s'y établit et à rester ensuite conducteur.

3. Sous-module (31) suivant la revendication 2,
**caractérisé en ce que**
les moyens de détection du cas de défaut ont un montage de capteur conçu pour détecter des grandeurs de contrôle du sous-module sous la forme d'une variation de tension, d'une variation de courant, d'un courant et/ou d'une tension chutant aux bornes de l'accumulateur d'énergie, le montage de capteur amorçant le thyristor (32) si la grandeur de contrôle dépasse une valeur de seuil fixée à l'avance.

4. Sous-module (31) suivant la revendication 2,
**caractérisé en ce que**
les moyens de détection du cas d'erreur ont une diode à avalanche aux bornes de laquelle chute la tension chutant aux bornes de l'accumulateur (16) d'énergie, la diode à avalanche étant reliée à l'entrée (33) de commande du thyristor (32) et conçue de manière à devenir conductrice lorsqu'une tension limite fixée à l'avance est dépassée.

5. Sous-module (31) suivant la revendication 2,
**caractérisé en ce que**
les moyens de détection du cas de défaut ont des moyens (34) de couplage, qui sont reliés du côté de la sortie à l'entrée de commande du thyristor (32), les moyens (34) de couplage étant couplés par induction à une ligne (36) de liaison, qui s'étend entre l'accumulateur (16) d'énergie et le montage (17, 26) à semi-conducteur.

6. Sous-module (31) suivant l'une des revendications précédentes,
**caractérisé en ce que**
les composants à semi-conducteur ont un thyristor (32) et une diode de roue libre, dans lequel tant le thyristor (32) qu'également la diode de roue libre sont montés en parallèle à basse induction avec l'accumulateur (16) d'énergie.

7. Sous-module (31) suivant l'une des revendications précédentes,
**caractérisé en ce que**
chaque unité (39) de montage a une paroi (44) latérale isolante électriquement et fermée sur le pourtour, dont la hauteur est un peu plus petite que la hauteur de la diode (20, 43) à avalanche, la plaque (41) d'émetteur, la plaque (42) de collecteur et la paroi (44) latérale formant un boîtier de circuit.

8. Sous-module (31) suivant la revendication 7,
**caractérisé en ce que**
la paroi (44) latérale est maintenue à complémentarité de forme par la plaque (41) d'émetteur et/ou par la plaque (42) de collecteur.

9. Sous-module (31) suivant l'une des revendications précédentes,
**caractérisé en ce qu'**
au moins un composant (32) à semi-conducteur est équipé d'un refroidissement.

10. Sous-module (31) suivant l'une des revendications précédentes,
**caractérisé en ce que**
le montage (17) à semi-conducteur forment ensemble avec l'accumulateur (16) d'énergie un montage en demi-pont.

11. Sous-module (31) suivant l'une des revendications précédentes,
**caractérisé en ce que**
le montage (17, 26) à semi-conducteur forment ensemble avec l'accumulateur (16) d'énergie un circuit en pont complet.

12. Sous-module (31) suivant la revendication 10 ou 11,
**caractérisé en ce que**
le montage (17, 26) à semi-conducteur a deux ou quatre montages en série d'unités de circuit.

13. Sous-module (31) suivant l'une des revendications précédentes,
**caractérisé en ce que**
chaque unité (39) de circuit est équipée de moyens (47, 48, 49, 50, 52, 57) de court-circuit supplémentaires, qui sont conçus pour court-circuiter la plaque (41) d'émetteur et la plaque (42) de collecteur en cas de défaut.

14. Sous-module (31) suivant la revendication 13,
**caractérisé en ce que**
chaque interrupteur (18, 19, 27, 28) à semi-conducteur de puissance est équipé d'une unité (39) de circuit ayant au moins deux segments à semi-conducteur de puissance montés en parallèle l'un par rapport à l'autre, qui ont chacun deux bornes de charge sous la forme d'une borne (5) de collecteur ou d'une borne (4) d'émetteur, les moyens de court-circuit ayant des moyens (47, 48, 52, 57) de détection d'une répartition dissymétrique du courant sur les bornes (4, 5) de charge de l'interrupteur (18, 19, 27, 28) à semi-conducteur de puissance.

15. Sous-module (31) suivant la revendication 14,
**caractérisé en ce que**
les moyens de détection d'une répartition de courant dissymétrique ont au moins un capteur (52) de mesure, qui est/sont conçu(s) pour détecter un flux de courant sur au moins deux bornes (4, 5) de charge ou pour détecter une grandeur se déduisant dudit flux de courant.

16. Sous-module (31) suivant la revendication 14,
**caractérisé en ce que**
les moyens de détection d'une répartition de courant dissymétrique ont une culasse (47) à magnétisme doux et au moins un capteur (52) de mesure, qui est conçu pour détecter un champ magnétique dans la culasse (47) à magnétisme doux.

17. Sous-module (31) suivant l'une des revendications 14 à 16,
**caractérisé en ce que** les moyens de court-circuit ont un interrupteur (50) de shuntage, qui est relié aux moyens (47, 48, 52, 57) pour détecter une répartition de courant dissymétrique de façon à ce que l'interrupteur (50) de shuntage soit fermé en présence d'une répartition de courant dissymétrique.
